# EUROPÄISCHE PATENTSCHRIFT

(11) **EP 0 873 575 B1**
(45) Veröffentlichungstag und Bekanntmachung des Hinweises auf die Patenterteilung: **26.02.2003**
(21) Anmeldenummer: 96945973.4
(22) Anmeldetag: 01.11.1996
(51) Int. Cl.: H01L 21/00, C23C 16/44

(54) **VORRICHTUNG ZUR HERSTELLUNG OXIDISCHER DÜNNSCHICHTEN**
DEVICE FOR PRODUCING OXIDIC THIN FILMS
SYSTEME DE FABRICATION DE COUCHES MINCES OXYDIQUES

(43) Veröffentlichungstag der Anmeldung: 28.10.1998
(73) Patentinhaber: Theva Dünnschichttechnik GmbH, 85386 Eching-Dietersheim (DE)
(72) Erfinder: KINDER, Helmut, D-85354 Freising (DE)
(74) Vertreter: Hess, Peter K., Dipl.-Phys.
(86) Internationale Anmeldenummer: DE9602096
(87) Internationale Veröffentlichungsnummer: WO98020521

(56) Entgegenhaltungen:
- EP-A- 0 426 570
- EP-A- 0 526 843
- EP-A- 0 595 300

## Beschreibung

Die Erfindung betrifft eine Vorrichtung zur Herstellung oxidischer Dünnschichten nach dem Oberbegriff des Anspruchs 1.

Oxidische Dünnschichten sind moderne Funktionswerkstoffe der Elektronik und Elektrotechnik. Dabei handelt es sich um chemische Verbindungen von meist mehreren metallischen Elementen mit Sauerstoff. Je nach Zusammensetzung ergeben sich Hochtemperatur-Supraleiter, Ferroelektrika, magnetoresistive Schichten oder Ferromagnetika.

Beispiele für Anwendungen der Dünnschichten aus Hochtemperatur-Supraleitern sind Magnetfeldsensoren (SQUIDs) mit zugehörigem Transformator, Antennen für Kernresonanztomographie und Kernresonanz-Analyse, Filter und Antennen im Mikrowellenbereich für Mobilfunk und Satelliltenfunk, Strombegrenzer in der Energietechnik, beschichtete Bänder als Leiter für Magnetspulen und zur Energieübertragung u. v. a. m.

Ferroelektrische oxidische Dünnschichten werden z. B. als nichtflüchtige Schreib-Lesespeicher (RAM) und zur permanenten Abstimmung von Mikrowellenfiltern eingesetzt, magnetoresistive Schichten als Leseköpfe für Computer-Festplatten, und ferromagnetische Dünnschichten allgemein für magnetische Speichermedien und auch für Mikrowellenkomponenten.

Für die meisten Anwendungen werden Dünnschichten mit großer Fläche benötigt. Aber auch kleinere Bauelemente können auf großer Fläche in großer Stückzahl gleichzeitig produziert werden, so daß ein wirtschaftlicher Vorteil entsteht. Ein industrielles Produktionsverfahren muß daher in der Lage sein, große Flächen mit gleichmäßiger reproduzierbarer Qualität zu beschichten.

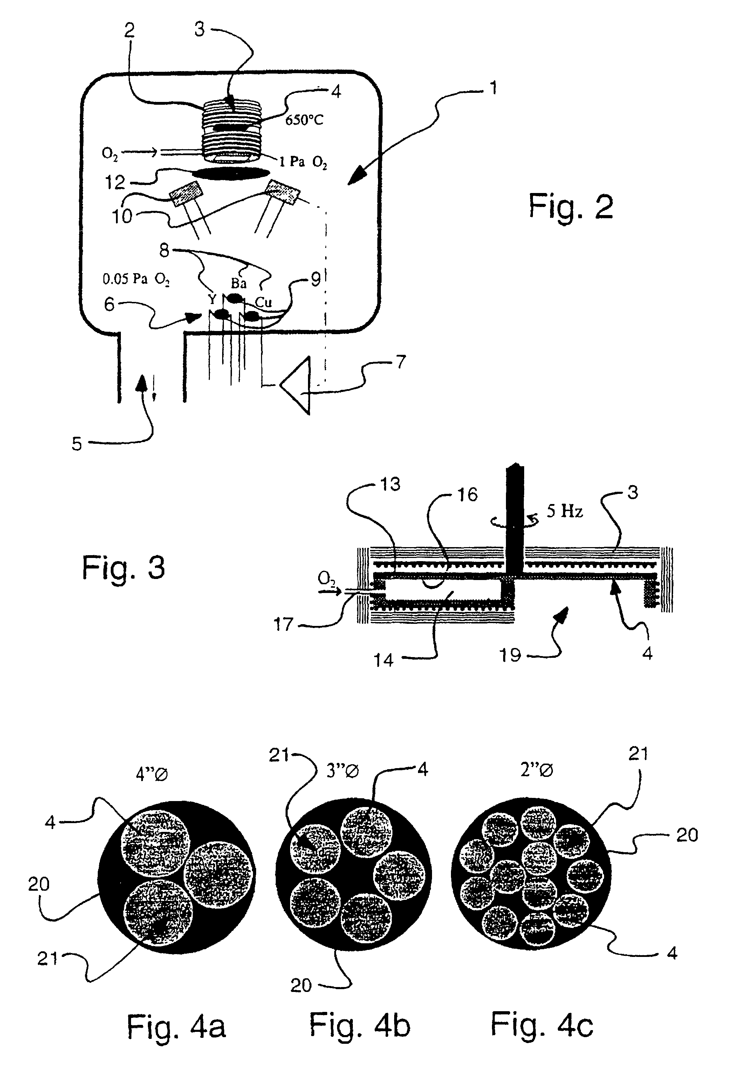

Für kleine und mittlere Flächen bis ca. 75 mm (etwa 3 Zoll) Durchmesser gibt es eine Reihe von geeigneten Verfahren und Vorrichtungen. Die wichtigsten sind Katodenzerstäubung (Sputtern), Laser-Ablation, Chemische Abscheidung aus metallorganischen Verbindungen (MOCVD) und Ko-Verdampfen der Metalle in Sauerstoffatmosphäre. Von dem letzteren soll zunächst das aus der Praxis bekannte Grundprinzip des thermischen Verdampfens unter Bezugnahme auf die Prinzipdarstellung in der Fig. 2 beschrieben werden.

Hier werden in einer Vakuumanlage die metallischen Elemente einzeln verdampft, wobei die jeweiligen Abscheideraten so geregelt werden, daß die gewünschte Zusammensetzung der Dünnschicht erreicht wird. Gleichzeitig mit den Metallatomen wird der auf dem Substrat aufwachsenden Dünnschicht Sauerstoff zugeführt, so daß das Oxid gebildet wird. Bei genügendem Abstand der Verdampfungsquellen zum Substrat wird die Beschichtungsrate auch auf großen Flächen homogen. Als Quellen kommen Elektronenstrahlverdampfer, Knudsen-Zellen und direkt durch Stromdurchgang geheizte Aufdampfschiffchen in Frage.

Geheizte Aufdampfschiffchen haben den Vorteil, daß sich ihre Verdampfungsraten stabil regeln lassen und daß sie unempfindlich gegen den in der Anlage stets vorhandenen Sauerstoff sind. Zudem sind die kleinen Abmessungen direkt geheizter Aufdampfschiffchen ein großer Vorteil, da sie erlauben, die Quellen besonders eng nebeneinander anzuordnen. Dadurch wird erreicht, daß beispielsweise drei Metalle nahezu aus demselben Punkt verdampft werden. Dann kann die Richtcharakteristik der Quellen nur zu geringen Gradienten der Zusammensetzung führen, wodurch sich eine hinreichend homogene Qualität der Schicht auch über große Flächen ergibt.

Da die Beschichtung in der Regel bei erhöhter Temperatur erfolgt (300 bis 800 °C), befindet sich hier das Substrat in einem senkrecht gestellten, kleinen Rohrofen, der eine indirekte Heizung durch Wärmestrahlung erlaubt. In diesen Ofen wird der Sauerstoff eingeleitet. Der Sauerstoffdruck im Ofen ist ca. 20 mal höher als in der übrigen Kammer, da diese ständig abgepumpt wird. Dies erlaubt ausreichende Oxidation des Substrats und trotzdem geradlinige Ausbreitung der Metallatome ohne wesentliche Streuung.

Die hier beschriebene Grundversion eignet sich jedoch nicht für große Flächen, da der Rohrofen nicht beliebig vergrößert werden kann. Wird sein Durchmesser vergrößert, so wächst auch die Flugstrecke der Metallatome durch das dichtere Sauerstoffgas vor dem Substrat. Daher erfahren die Metallatome so starke Streuung, daß die Abscheiderate druckabhängig wird und nicht mehr mit genügender Präzision geregelt werden kann. Es wurden in der Praxis nur Flächen bis 3 x 3 cm² hergestellt, wobei bereits Abstriche hinsichtlich der Qualität zu machen waren.

Daher wurde eine rotierende Anordnung entwickelt, bei der die Aufdampfzone und die Oxidationszone räumlich getrennt sind. Dieses Drehteller-Prinzip ist in der Fig. 3 skizziert. Das oder die Substrat(e) werden auf einem sich drehenden Teller angeordnet, der wieder durch Wärmestrahlung beheizt wird. Die Achse des Drehtellers wird durch eine Drehdurchführung nach außen geführt und von einem Motor angetrieben, der sich an Luft befindet.

Auf der Unterseite des Drehtellers wird eine Platte angeschraubt, auf der die Substrate liegen. Die Platte hält die Substrate (Wafer) nur an deren Rand und läßt die übrige Waferfläche frei, so daß diese von unten bedampft werden kann. Durch die Rotation mit ca. 300 bis 600 U/min, wird der Wafer bereits nach der Bedampfung mit ca. 1 Atomlage weiterbewegt in eine Tasche, in die Sauerstoff zugeführt wird. Dort wird diese Atomlage oxidiert, und es bildet sich die gewünschte Verbindung.

Die Sauerstofftasche sollte möglichst ideal abgedichtet sein, um eine möglichst große Druckdifferenz zum übrigen Rezipienten zu gewährleisten. Da bei den hohen Temperaturen keine Dichtungsmaterialien verwendet werden können. und eine materielle Dichtung außerdem durch Abrieb die aufwachsende Schicht stark verunreinigen würde, wird anstelle einer Dichtung ein kontrollierter Strömungswiderstand verwendet, der durch den Spalt zwischen dem sich drehenden Teller und dem Rand der feststehenden Sauerstofftasche gebildet wird.

Der Strömungswiderstand wächst mit der Länge des Spalts und umgekehrt proportional zum Quadrat seiner Breite. Es ist daher besonders wichtig, den Spalt möglichst eng zu halten. Dem sind Grenzen gesetzt durch die Mechanik, die bei größeren Durchmessern kritischer wird. Daher erlaubt ein Drehteller mit Mittelachse nur die Beschichtung von Flächen mit bis zu 10 cm Durchmesser.

Diese Begrenzung rührt daher, daß die Mittelachse durch Wärmeleitung stark miterwärmt wird und sich durch Wärmeausdehnung verlängert und verzieht. Die Verlängerung führt dazu, daß sich der Spalt temperaturabhängig verengt. Dies läßt sich für eine gewünschte Temperatur im Prinzip dadurch kompensieren, indem der Spalt bei Zimmertemperatur zu weit eingestellt wird. Jedoch ist diese Prozedur mühsam und gelingt nur näherungsweise. Eine nicht zu vermeidende Schwierigkeit ist aber, daß die Achse sich gleichzeitig auch verzieht. Dies führt dazu, daß der Drehteller nicht mehr parallel zur Sauerstofftasche justiert ist und zu streifen beginnt. Durch das Streifen bildet sich Abrieb, der bei den hohen Temperaturen zusammensintert und sich ablagert. Dadurch wird das Streifen rasch verstärkt, bis der Drehteller völlig zum Stillstand kommt. Je größer der Durchmesser des Tellers, desto kleinere Verbiegungen der Achse reichen aus, um diesen Prozeß auszulösen. Daher sind Drehteller, die durch eine Mittelachse gehaltert werden, nur bis ca. 10 cm Durchmesser praktikabel.

Ferner ist aus EP 0 595 300 eine CVD-(Chemical Vapor Deposition) Vorrichtung zur großtechnischen Beschichtung von Wafern bekannt, bei der mehrere Wafer in einer Ebene auf einem drehbaren Träger angeordnet sind. Unabhängig vom dem Träger ist gegenüber der Fläche zur Befestigung der Wafer eine Gasabscheidungsvorrichtung angeordnet. Ferner ist eine Heizung vorgesehen, die die Wafer von ihrer Rückseite her indirekt heizt. Um einen gleichförmigen Film zu erzeugen, werden während der Gasabscheidung die Wafer hin- und herbewegt, wodurch die Qualität des erzeugten Films verbessert wird. Durch eine Drehbewegungen des Trägers können nacheinander weitere Wafer dem Bereich der Gasabscheidung zugeführt werden. Während des Depositionsprozesses werden die Wafer auf einer konstanten Temperatur von ungefähr 350 °C gehalten.

Das Ziel der Erfindung ist es, eine Vorrichtung zur Herstellung oxidischer Dünnschichten zu schaffen, bei der die genannten Schwierigkeiten vermieden und mit der Bedampfungsflächen von 20 cm Durchmesser und darüber ermöglicht werden.

Dieses Ziel wird mit einer Vorrichtung zur Herstellung oxidischer Dünnschichten nach dem Anspruch 1 erreicht.

Eine erfindungsgemäße Vorrichtung zur Herstellung oxidischer Dünnschichten enthält demgemäß eine Vakuumkammer, in der eine Sauerstoffkammer mit einer Öffnung und ein letztere überdeckender drehbarer Substrathalter angeordnet sind. Zur drehbaren Anordnung des Substrathalters ist eine Drehhalterung vorgesehen, die in einem Umfangsbereich des Substrathalters angreift. Dadurch ist die gesamte Fläche des Substrathalters frei für die Aufnahme eines Substrats oder mehrerer Substrate und nicht durch die Antriebsachse gestört. Ferner ermöglicht diese Art der Umfangshalterung in vorteilhafter Weise einen ruhigeren und genaueren Lauf der Drehung des Substrathalters insbesondere gegenüber der Sauerstoffkammer. Ein weiterer Vorteil dieser Ausgestaltung liegt darin. daß Temperatureinflüsse auf die Drehhalterung und deren Antrieb minimiert werden können. Die Erfindung geht somit über den Stand der Technik hinaus, indem sie die Mechanik durch geeignete Maßnahmen verbessert.

Gemäß einer bevorzugten Weiterbildung der Erfindung ist vorgesehen, daß die Drehhaiterung eine Einstellung der Neigung des Substrathalters gegenüber und/oder des Abstandes des Substrathalters von der Öffnung der Sauerstoffkammer zuläßt. Dadurch können der Lauf der Drehung des Substrathalters und der Abstand des Substrathalters von der Öffnung der Sauerstoffkammer optimiert werden.

Bei einer weiteren vorteilhaften Fortbildung der Erfindung enthält die Drehhalterung einzelne voneinander beabstandete Dreharme, insbesondere drei oder mehr Dreharme, und diesen zugeordnete Abhängstreben, die im Umfangsbereich des Substrathalters angreifen und die Dreharme mit dem Substrathalter verbinden. Die Dreharme können vorzugsweise rechteck- oder parallelogrammartig ausgebildet sein. Ferner können die Dreharme bevorzugt mittels Zwischenteilen, z.B. Unterlegscheiben oder allgemein Keramikbauteilen, mit einem erhöhten Wärmeübergangswiderstand mit den Abhängstreben verbunden sein. Damit hat die Wärmeausdehnung dieser Komponenten in den einzelnen Realisierungsversionen jeweils geringste Auswirkungen auf ein Verziehen und Schlagen des Substrathalters im Betrieb. Außerdem wird durch diese Ausgestaltungen die Beschickung des Substrathalters wesentlich erleichtert.

Eine Verstellbarkeit des Substrathalters gegenüber der Sauerstoffkammer kann vorteilhaft dadurch realisiert werden, daß zumindest ein Dreharm und bevorzugt alle Dreharme insbesondere zum Verstellen des Abstandes des Substrathalters von der Öffnung der Sauerstoffkammer justierbar ist bzw. sind, und daß zur Justierung des wenigstens einen Dreharms vorzugsweise eine Stellvorrichtung zur bevorzugt elastischen Deformation der ggf. rechteckoder parallelogrammartigen Ausgestaltung des Dreharms vorgesehen ist. Diese Ausführungen vereinen eine einfache, gute und differenzierte Einstellbarkeit des Substrathalters mit möglichst geringer Wärmeleitung der Drehhalterung.

Beispielsweise kann ein Dreharm dadurch in rechteckartiger Ausgestaltung hergestellt werden, indem eine Rechteckplatte entsprechend ausgefräst wird. Damit werden gleichzeitig eine geringe Wärmeleitfähigkeit und eine ausreichende Stabilität bei geringen bewegten Massen erreicht. Die Querschnitte der verbleibenden Bereiche in Form der rechteckartigen Ausgestaltung können möglichst klein gehalten werden. Eine ggf. vorhandene Einstellbarkeit der Dreharme wird dadurch erleichtert, daß im Bereich der oder nahe den Ecken der Rechteck- oder allgemein Parallelogrammform der Dreharme schwachstellenartige Einschnitte enthalten sind, die eine Parallelogrammverformung begünstigen und in vorteilhafter Weise gleichzeitig eine Wärmeübertragung erschweren.

Eine Stellvorrichtung zum Verstellen des Substrathalters gegenüber der Sauerstoffkammer kann z.B. bezogen auf eine Rechteckform der Dreharme dazu schräg gestellte Schraubenbolzen in jedem einstellbaren Dreharm enthalten. Die beiden Schraubenbolzen werden durch eine Muffe mit Innengewinde zusammengehalten. Die Bolzen haben je ein anderes Gewinde, wie beispielsweise ein Rechtsgewinde bei einem Bolzen und eine Linksgewinde beim anderen Bolzen, oder Gewinde mit unterschiedlichen Steigungen oder mit unterschiedlichem Gewindehub. Die Muffe weist entsprechend passende Innengewinde auf, so daß die Verstellung der Muffe eine Kontraktion oder Streckung der Anordnung und damit eine z.B. elastische Deformation des Dreharms in der Form eines Parallelogramms bewirkt. Dies führt zu einem Absenken oder Anheben der Abhängstreben der Drehhalterung. Damit kann der Substrathalter genau eben in Bezug auf eine durch ein Lager der Drehhalterung bestimmte Ebene und somit auf die durch das Lager der Drehhalterung bestimmte Achse eingestellt werden. Durch diese Einstellmöglichkeit kann ferner der Abstand oder die Spaltbreite zwischen dem Substrathalter und der Sauerstofftasche einfach und optimal eingestellt werden.

Bei einer weiteren vorteilhaften Ausgestaltung ist vorgesehen, daß die Sauerstoffkammer mittels vorzugsweise justierbarer Haltestreben positioniert ist, die hinsichtlich der Abhängstreben der Drehhalterung zumindest weitgehend parallel verlaufen und auf einem geringfügig größeren Kreisumfang liegen, und daß vorzugsweise ferner die Abhängstreben der Drehhalterung und die Haltestreben der Sauerstoffkammer dasselbe Material enthalten oder aus demselben Material bestehen und/oder dieselben oder ähnliche Querschnitte aufweisen. Damit wird eine weitgehende gegenseitige Kompensation der Wärmeausdehnung der Abhängstreben und der Haltestreben und eine geringste Änderung der Spaltweite zwischen der Sauerstoffkammer oder -tasche und dem Substrathalter erreicht.

Somit kann generell alleine oder in Kombination auch die Sauerstofftasche oder -kammer gegenüber dem Substrathalter justiert werden, indem die entsprechenden Haltestreben z.B. mittels ihrer Befestigungsschrauben justiert werden. Mit Vorteil können die Befestigungsschrauben der Haltestreben mit Tellerfedern oder anderen federnden Elementen elastisch gekontert sein. Durch diese Justierbarkeit kann erstens die Sauerstoffkammer genau eben in Bezug auf eine durch ein Lager der Drehhalterung bestimmte Ebene und somit auf die durch das Lager der Drehhalterung bestimmte Achse und zweitens die Spaltbreite zwischen der Sauerstoffkammer und dem Substrathalter eingestellt werden.

Zur weiteren Verminderung der Wärmeleitung über die Abhängstreben und die Haltestreben können letztere einen minimalen Querschnitt aufweisen. Beispielsweise können diese Streben durch Blechstreifen gebildet sein, die durch ihre Geometrie den weiteren Vorteil haben, daß sie bei entsprechender Stellung der Drehhalterung sehr dicht beieinander liegen können und sich so hinsichtlich ihrer Temperaturausdehnung weitgehend gleich verhalten. Neben der guten Aufrechterhaltung des zwischen der Sauerstoffkammer und dem Substrathalter eingestellten Abstandes ergibt sich hierbei auch eine gute Wärmeisolation der in einer Vorrichtung zur Herstellung von Dünnschichten üblichen heißen Zone. Dies hat wiederum u.a. zur Folge, daß eine geringere Heizleistung erforderlich ist und sich die gesamte Vorrichtung, die auch als Aufdampfanlage bezeichnet werden kann, oder einzelne Baugruppen und Komponenten davon weniger erwärmt bzw. erwärmen.

In weiterer vorteilhafter Fortbildung der Erfindung kann vorgesehen sein, daß der Substrathalter einen Ring enthält, in den wenigstens eine Trägerscheibe einlegbar ist, die zum haltenden Aufnehmen von zumindest einem Substrat ausgelegt ist. Gemäß einer Ausgestaltung der Erfindung besteht der Substrathalter somit aus einem Ring, in dessen Umfangsbereich die Drehhalterung und genauer ggf. deren Abhängstreben angreift bzw. angreifen, und einer in den Ring eingelegten Scheibe, die ihrerseits Ausfräsungen zur Aufnahme von Substraten enthält. Dabei kann die Trägerscheibe besonders vorteilhaft aus Keramik bestehen. Durch eine solche Anordnung können ggf. sogar mehrere Substrate gleichzeitig und sehr einfach in den Substrathalter eingesetzt und daraus entnommen werden, indem die Trägerscheibe zusammen mit allen darauf oder darin liegenden Substraten gehandhabt wird. Damit kann eine Automatisierung der Beschickung des Substrathalters erzielt werden.

Bei einer anderen vorteilhaften Weiterbildung der Erfindung kann die Drehhalterung an einer feststehenden Achse drehbar gelagert sein, wobei weiterhin die feststehende Achse vorzugsweise gekühlt und insbesondere wassergekühlt sein kann. Ferner kann die Lagerung der Drehhalterung des Substrathalters bevorzugt nahe bei letzterem liegen. Dadurch ergibt sich eine gute Kühlung des Lagers, wie beispielsweise einer Kugellagerung, zur Drehlagerung der Drehhalterung sowie eine erhöhte Stabilität des Aufbaus. Im Falle der Verwendung einer Kugellagerung kann diese durch mehrere einzelne Kugellager gebildet sein, die dann vorzugsweise zur weiteren Stabilitätserhöhung gegeneinander verspannt sein können.

Ein weiterer Schutz der Lagerung der Drehhalterung an der feststehenden Achse kann mit Vorteil dadurch erreicht werden, daß an der feststehenden Achse ein zwischen der Lagerung der Drehhalterung des Substrathalters und dem Substrathalter ein Wärmeschild angeordnet und vorzugsweise integral mit der feststehenden Achse ausgebildet ist, und/oder daß die feststehende Achse und ggf. das Wärmeschild zumindest im wesentlichen aus einem gut wärmeleitenden Material besteht bzw. bestehen. Diese Ausgestaltungsmöglichkeiten können dadurch ergänzt werden, daß das Wärmeschild einen an die Kühlung der feststehenden Achse angeschlossenen Kühlkörper und/oder eine Mehrzahl von lamellenartigen oder folienartigen Strahlungsschilde enthält, wobei letztere ggf. zwischen dem Kühlkörper und dem Substrathalter liegen. Auf diese Weise wird eine einfache und wirksame weitergehende Temperaturabschirmung und ggf. Kühlung des Lagers der Drehhalterung gegenüber dem in der sog. heißen Zone der Anordnung liegenden Substrat erreicht. Dies wirkt sich positiv auf die Erhaltung des Abstandes zwischen der Sauerstoffkammer und dem Substrathalter und auf die Aufrechterhaltung eines optimalen Laufs und einer gleichbleibenden Ausrichtung der Drehhalterung aus. Die Strahlungsschilde lassen sich durch einen Stapel aus Folien besonders unaufwendig realisieren. Eine andere Bauart sind über Stege gegeneinander abgestützte dünne Bleche o.ä.

Um auf der gesamten zu bedampfenden Fläche eine möglichst homogene Temperatur zu erzielen, ist es vorteilhaft, wenn zwischen dem Wärmeschild und dem Substrathalter eine Oberseitenheizung vorgesehen ist. Diese kann vorteilhafterweise durch die feststehende Achse hindurch betriebsmäßig versorgt werden. Beispielsweise können elektrische Zuleitungen durch Bohrungen in der Achse ggf. neben einem Kanal oder Kanälen der Wasserkühlung zur Oberseitenheizung geführt werden.

Weiterhin kann zum Erreichen einer möglichst homogene Temperatur auf der gesamten zu bedampfenden Fläche um den Umfangsverlauf des Substrathalters eine Umfangsheizung und/oder vorgesehen sein, daß die Sauerstoffkammer insbesondere mittels einer an deren dem Substrathalter abgewandten Seite angeordneten Unterseitenheizung geheizt wird. Demselben Zweck kann weiterhin dienen, daß im Bereich des Substrathalters außerhalb der Sauerstoffkammer eine Aufdampfzone gebildet ist, die durch einen zum Substrathalter hin gerichteten Aufdampfkamin begrenzt ist, und daß bevorzugt eine Kaminheizung zum Heizen des Aufdampfkamins vorgesehen ist und/oder für den Substrathalter auf seiner dem Aufdampfkamin zugewandten Seite in seinem außerhalb des Aufdampfkamins liegenden Bereich eine Unterseitenheizung angeordnet ist. Durch Kombination der einzelnen Heizungen kann erreicht werden, daß diese den gesamten Substrathalter einschließen, um Hohlraumstrahlung anzunähern. Dadurch wird in optimaler Weise eine homogene Temperatur auf der gesamten bedampften Fläche gewährleistet.

Ähnlich der Abschirmung der Oberseitenheizung durch das Wärmeschild gegen Wärmeabstrahlung vom Substrathalter weg, können auch die Umfangsheizung und/oder die Unterseitenheizung auf ihren dem Substrathalter abgewandten Seiten und/oder die Kaminheizung auf ihrer dem Aufdampfkamin abgewandten Seite thermisch abgeschirmt sein.

Eine weitere Ausgestaltung der Erfindung befaßt sich mit der Bauweise der Heizungen. Demnach können die Oberseitenheizung, die Umfangsheizung, die Unterseitenheizung und/oder die Kaminheizung je ggf. insbesondere dicht liegende Mantelheizleiter enthalten, die vorzugsweise durch mechanische Verbindungsmittel und besonders bevorzugt unverlötet an Heizleiterträgern angebracht sind. Es ist von Vorteil, wenn alle Heizflächen möglichst dicht mit Mantelheizleitern belegt sind. Dadurch ergibt sich eine große abstrahlende Heizerfläche. Für eine gegebene oder erforderliche Strahlungsleistung ergibt sich so eine möglichst niedrige Temperatur der Heizer. Dadurch kommt es zu einem entsprechend geringen Abdampfen von Verunreinigungen, was wiederum eine bessere Qualität der herzustellenden Dünnschichten zu Folge hat. Außerdem wird die Lebensdauer der Heizleiter dadurch verlängert. Durch Befestigung der Mantelheizleiter ohne Hartlöten o.ä. durch beispielsweise Anbinden mit einem dünnen Edelstahldraht wird in vorteilhafter Weise ein Abdampfen von Verunreinigungen aus dem Lot vermieden. Ferner treten weniger mechanische Spannungen beim Erwärmen und Abkühlen der Heizelemente auf, was u.a. wiederum die Lebensdauer der Heizleiter verlängert. Diesen Aspekte kommt auch eigenständige erfinderische Bedeutung zu.

Beim Bedampfen von Substraten wird i.d.R. keine exakt gleichbleibende Schichtdikke erreicht. Die Schichtdicke ist unmittelbar über den Bedampfungsquellen am größten und nimmt bezogen auf die Drehbewegung des Substrats in Radialrichtung einwärts und auswärts ab. Vor allem bei kleineren bedampften Flächen ist dieser Effekt für die Verwendbarkeit der hergestellten Dünnschichten kaum von Bedeutung. Um so größer aber die zu bedampfende Fläche ist, sei es auf einem einzigen großen Substrat oder gleichzeitig auf einer Mehrzahl von kleineren Substraten, um so mehr wirkt sich dieser Effekt jedoch qualitätsmindernd auf die Dünnschicht aus. Um dem entgegenzuwirken ist gemäß einem weiteren Gesichtspunkt der Erfindung, dem auch eigenständige Bedeutung beizumessen ist, vorgesehen, daß im Bereich des Substrathalters außerhalb der Sauerstoffkammer eine Aufdampfzone in Form eines Kreissegmentes gebildet und vorzugsweise durch eine Ausschnittssegmentblende begrenzt ist, die insbesondere längs der radial verlaufenden Segmentseiten konkav nach innerhalb der Aufdampfzone eingezogen ist. Dadurch wird die Wirkzeit der Bedampfung auf Grund der Drehung des Substrats über den Radius des Substrathalters so beeinflußt, daß unmittelbar über den Bedampfungsquellen eine geringere Aufdampfzeit zur Verfügung steht gegenüber dem Fall, daß die radial verlaufenden Segmentseiten linear verlaufen. Dies hat zur Folgen, daß die aufgedampfte Schichtdicke gleichmäßiger ist.

Eine weitere Gestaltungsvariante der Erfindung mit auch eigenständig erfinderischer Bedeutung besteht darin, daß zum Antrieb der Drehhalterung ein Motor innerhalb der Vakuumkammer angeordnet ist, der insbesondere ggf. im Bereich der Lagerung der Drehhalterung an der feststehenden Achse antriebsmäßig mit der Drehhalterung gekoppelt ist, und daß vorzugsweise eine metallische Transmission, die z.B. eine Schraubenfeder und Schnurräder, eine Kette mit Kettenrädern und/oder ein Zahngetriebe enthält, zur antriebsmäßigen Kopplung des Motors und der Drehhalterung vorgesehen ist. Einerseits wird dadurch die kurze Lebensdauer einer verschleißintensiven Durchführung von Antriebsübertragungsmitteln, wie beispielsweise einer Vakuumdrehdurchführung, von einem außerhalb der Vakuumkammer angeordneten Motors zur Drehhalterung vermieden. Andererseits ermöglicht diese Bauart, daß der Motor samt Antriebsmitteln mit der Drehhalterung als Baueinheit ausgeführt wird, die z.B. zum Zweck von Service- und Einstellarbeiten leicht auszubauen ist, so daß diese Arbeiten wesentlich erleichtert werden.

Der Motor innerhalb der Vakuumkammer oder allgemein innerhalb der Aufdampfanlage kann mit einer Kühlmanschette versehen sein, die beispielsweise wassergekühlt ist. Die Gestaltung der Transmission aus metallischen Teilen, wie z.B. einer Schraubenfeder und Schnurrädern, einer Kette mit Kettenrädern und/oder einem Zahngetriebe, vermeidet die Gefahr einer thermischen Zersetzung dieser Teile. Die Verwendung von Teilen aus anderen Materialien, die keine derartige Temperaturfestigkeit oder -beständigkeit aufweisen, würde zu Verunreinigungen infolge von Verbrennung derartiger Materialien und damit auch zur Funktionsunfähigkeit des Antriebs führen.

Eine weitere Erleichterung von Service- und Einstellarbeiten kann dadurch erreicht werden, daß in der Vakuumkammer Schubladenschienen angeordnet sind, auf denen einzelne innerhalb der Vakuumkammer liegende Baugruppen der Vorrichtung insbesondere ganz oder teilweise nach außerhalb der Vakuumkammer verschiebbar sind.

Vorzugsweise bestehen einzelne Komponenten insbesondere in geheizten Zonen der Vorrichtung ganz oder teilweise aus Edelstahl, Hochtemperaturstahl, wie z.B. Inconel, und/oder Keramik und/oder daß die Drehhalterung und/oder der Substrathalter ganz oder teilweise aus einem Material mit geringer Wärmeleitfähigkeit und/oder Wänneausdehnung. Insbesondere die Ausführung einiger oder aller Teile aus Keramik hat eine noch bessere Maßhaltigkeit und damit eine noch geringer einstellbare Spaltbreite zwischen der Sauerstoffkammer und dem Substrathalter bzw. dem Substrat zur Folge. Letzteres führt zu einem geringeren Sauerstofffluß durch den entsprechenden Spalt, so daß nur eine geringere Pumpleistung erforderlich ist und/oder ein noch größerer Substrathalter verwendet werden kann, um noch größere Substrate oder eine größere Anzahl gleichzeitig zu bedampfender Substrate behandeln zu können.

Bei einer anderen vorzugsweisen Ausgestaltung der Erfindung mit ebenfalls selbständiger erfinderischer Bedeutung ist vorgesehen, daß wenigstens eine Aufdampfvorrichtung, insbesondere ein Aufdampfschiffchen enthalten ist, die bzw. das außerhalb der Sauerstoffkammer liegend und ggf. dem Aufdampfkamin zugeordnet auf einer Kreislinie angeordnet ist, deren Radius zumindest ungefähr und bevorzugt genau die Hälfte des Radius des Substrathalters oder ggf. der Trägerscheibe mißt und deren Mittelpunkt mit der Achse des Substrathalters ausgerichtet ist, und daß vorzugsweise eine Mehrzahl von Aufdampfvorrichtungen bzw. Aufdampfschiffchen vorgesehen ist, die auf der Kreislinie dicht beieinander angeordnet sind. Dadurch wird die Schichtdicke gleichmäßig und Konzentrationsgradienten bei Dünnschichten, die mehrere Metallkomponenten enthalten, werden vermieden.

Ferner kann eine Mehrzahl von Aufdampfvorrichtungen, insbesondere Aufdampfschiffchen, und eine relativ dazu bewegliche Elektronenstrahlkanone vorgesehen sein. Bei dieser Ausführung ist die Elektronenstrahlkanone bevorzugt so in der Aufdampfanlage montiert, daß sie über die Aufdampfschiffchen bewegt werden kann. Dadurch können in-situ Pufferschichten und Deckschichten hergestellt werden, was beispielsweise für Mikrowellenfilter wichtig ist.

Eine bevorzugte einstellbare Größe des Abstandes des Substrathalters von der Öffnung der Sauerstoffkammer im Betrieb der Vorrichtung beträgt als 0,3 mm.

Weitere bevorzugte und vorteilhafte Ausgestaltungen der Erfindung ergeben sich aus den abhängigen Ansprüchen und deren Kombinationen. Weiterhin können darüber hinausgehende Merkmale aus dem Stand der Technik, wie er zu Beginn dieser Beschreibung dargestellt ist, mit den vorstehend und in den Ansprüchen beschriebenen Ausführungen kombiniert werden.

Die Erfindung wird nachfolgend anhand von Ausführungsbeispielen unter Bezugnahme auf die Zeichnung exemplarisch beschrieben, in der:
Fig. 1 eine schematische Schnittansicht durch einige wesentliche Komponenten einer Ausführung der Vorrichtung zur Herstellung oxidischer Dünnschichten zeigt,
Fig. 2 eine Prinzipskizze einer Grundversion zum thermisch reaktiven Dampfen aus Schiffchen darstellt,
Fig. 3 eine Drehtelleranordnung einer Vorrichtung zur Herstellung oxidischer Dünnschichten nach dem Stand der Technik mit Mittelachse schematisch verdeutlicht,
Fig. 4a - c Draufsichten auf verschiedene Ausführungen von Trägerscheiben mit eingesetzten Substraten sind,
Fig. 5 eine Konstruktionszeichnung der in der Fig. 1 gezeigten Ausführung der Vorrichtung zur Herstellung oxidischer Dünnschichten in einer Draufsichtsansicht ist,
Fig. 6 eine Konstruktionszeichnung der in der Fig. 5 gezeigten Ausführung der Vorrichtung zur Herstellung oxidischer Dünnschichten in einer Schnittansicht gemäß der Linie VI - VI in der Fig. 5 ist,
Fig. 7 eine teilweise schematische Darstellung der Achse und der Dreharme der in der Fig. 5 gezeigten Ausführung der Vorrichtung zur Herstellung oxidischer Dünnschichten in einer Draufsichtsansicht zeigt,
Fig. 8 a eine Seitenansicht einer Haltestrebe der in der Fig. 5 gezeigten Ausführung der Vorrichtung zur Herstellung oxidischer Dünnschichten darstellt,

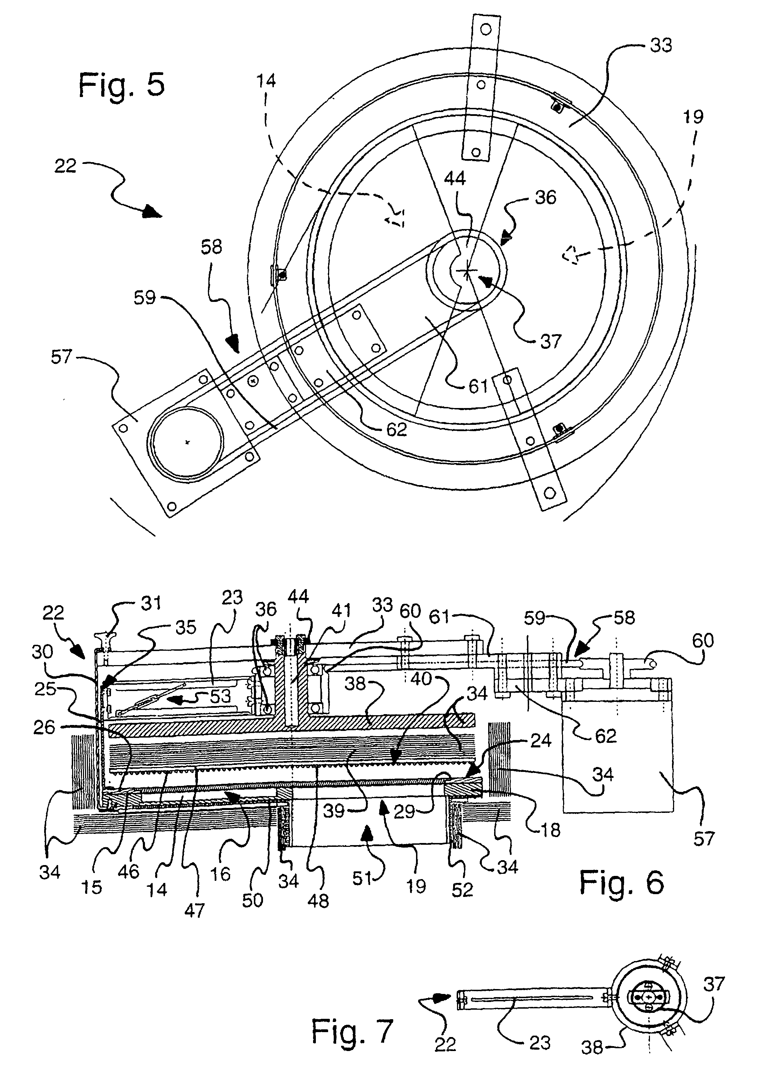

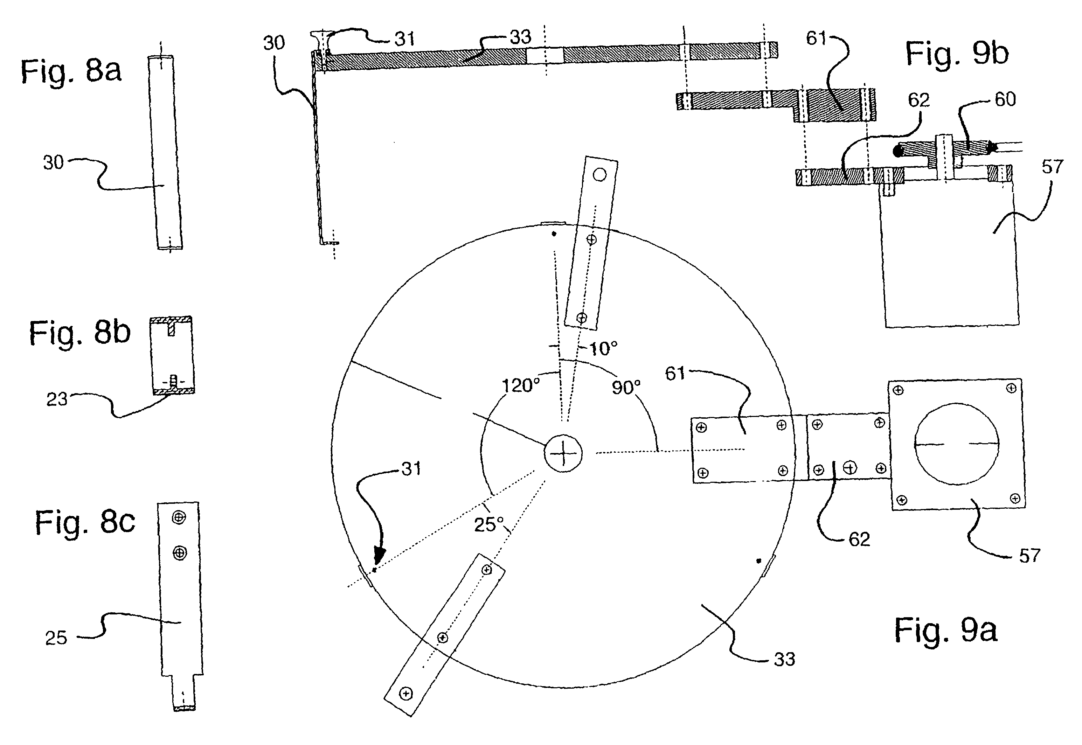

Fig. 8 b eine Seitenansicht eine Abhängstrebe der in der Fig. 5 gezeigten Ausführung der Vorrichtung zur Herstellung oxidischer Dünnschichten darstellt,
Fig. 8 c eine Querschnittsansicht eines Dreharms der in der Fig. 5 gezeigten Ausführung der Vorrichtung zur Herstellung oxidischer Dünnschichten ist,
Fig. 9 a - b Konstruktionszeichnungen einer Deckplatte mit Anbauteilen der in der Fig. 5 gezeigten Ausführung der Vorrichtung zur Herstellung oxidischer Dünnschichten in Draufsicht sowie im auseinandergezogenen Schnitt und mit Einzeldarstellungen der Haltestrebe sind,

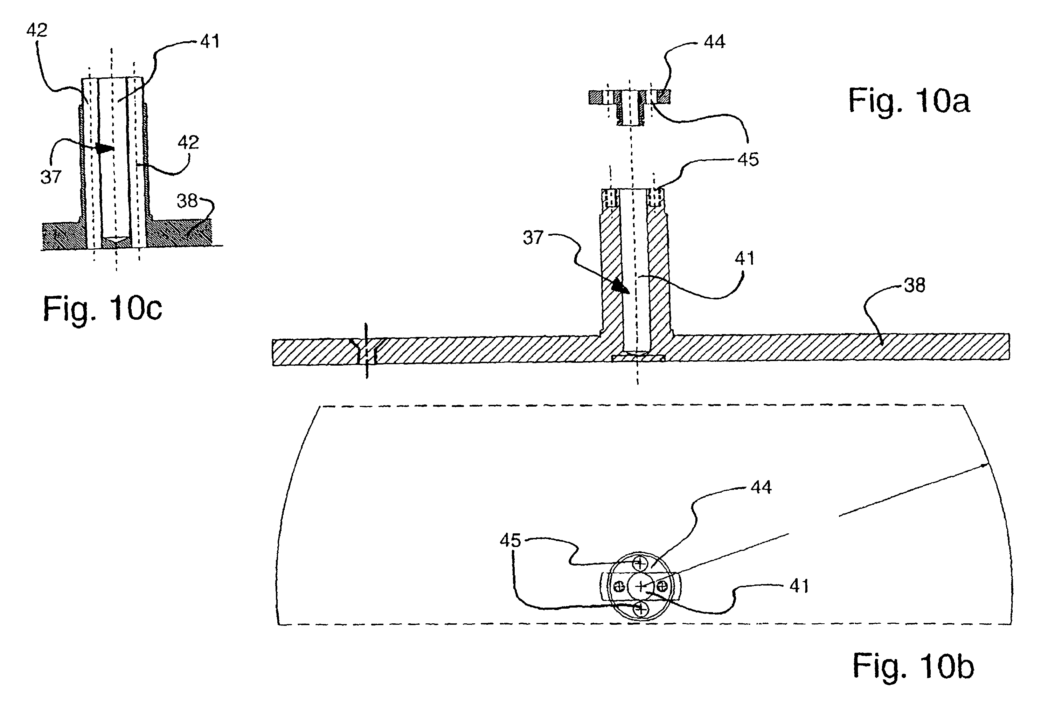

Fig. 10 a - b eine Querschnittsansicht und eine teilweise Draufsicht auf die Achse und den Kühlkörper des Wärmeschildes der in der Fig. 5 gezeigten Ausführung der Vorrichtung zur Herstellung oxidischer Dünnschichten zeigen,
Fig. 10 c weitere Einzelheiten der Achse und des Kühlkörpers des Wärmeschildes der in der Fig. 5 gezeigten Ausführung der Vorrichtung zur Herstellung oxidischer Dünnschichten in einer schematischen geschnittenen Teilansicht verdeutlicht,

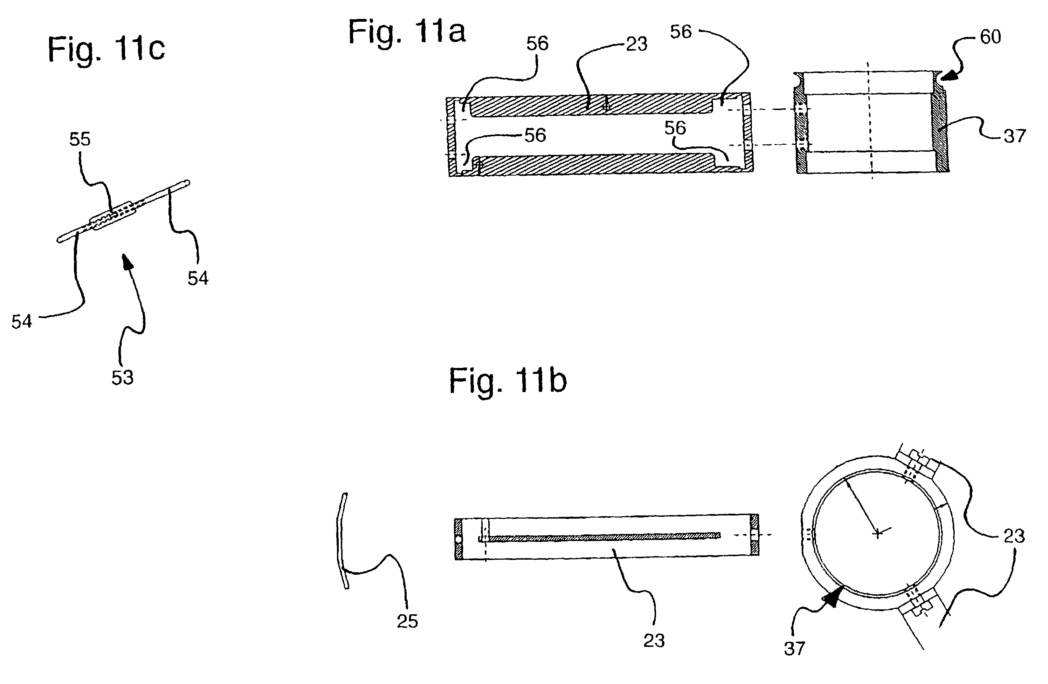

Fig. 11 a eine auseinandergezogene Darstellung einer Schnittansicht durch die Achse, einen Dreharm und eine Abhängstrebe der in der Fig. 5 gezeigten Ausführung der Vorrichtung zur Herstellung oxidischer Dünnschichten ist,
Fig. 11 b eine auseinandergezogene Darstellung einer Draufsicht auf die Achse, einen Dreharm und eine Ausführung einer Abhängstrebe der in der Fig. 5 gezeigten Ausführung der Vorrichtung zur Herstellung oxidischer Dünnschichten zeigt,
Fig. 11 c eine Prinzipskizze einer Stellvorrichtung zum Justieren des in den Fig. 11 a und b gezeigten Dreharms verdeutlicht,

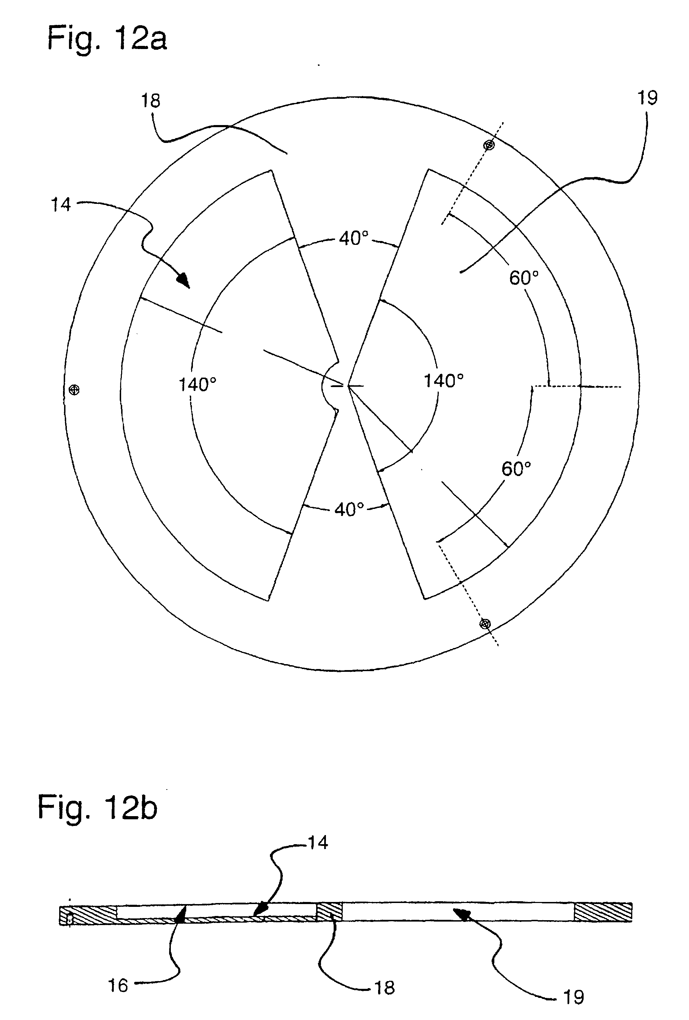

Fig. 12 a - b eine Draufsicht auf bzw. eine Schnittansicht durch eine Abschlußplatte mit einer Sauerstoffkammer und einem Aufdampfzonensegmentausschnitt der in der Fig. 5 gezeigten Ausführung der Vorrichtung zur Herstellung oxidischer Dünnschichten darstellt,

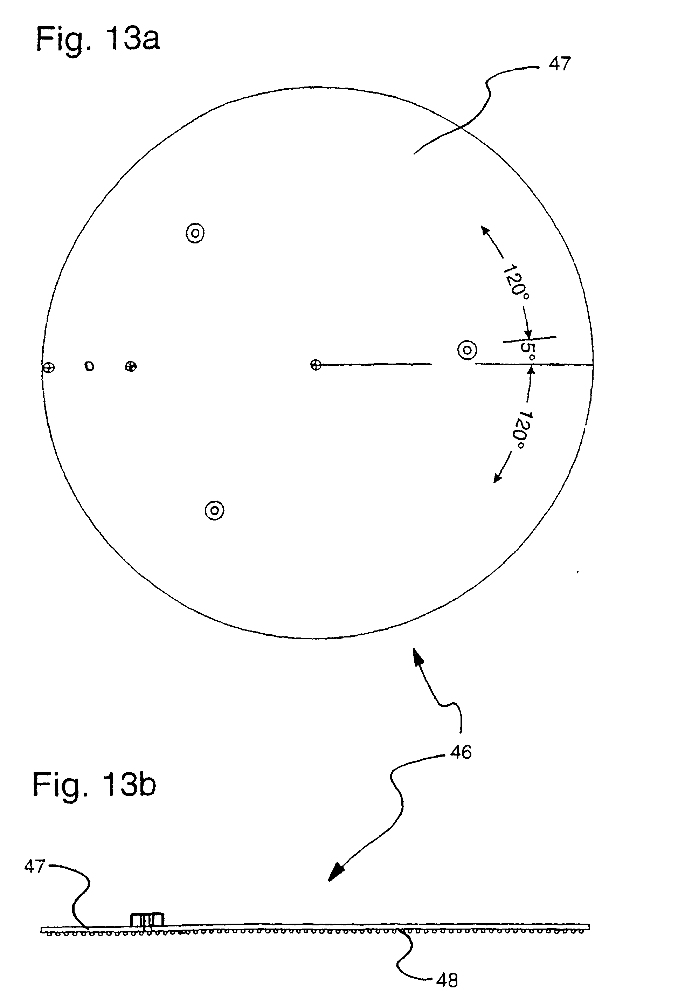

Fig. 13 a - b eine Draufsicht auf bzw. eine Schnittansicht durch eine Heizerplatte der in der Fig. 5 gezeigten Ausführung der Vorrichtung zur Herstellung oxidischer Dünnschichten zeigt,

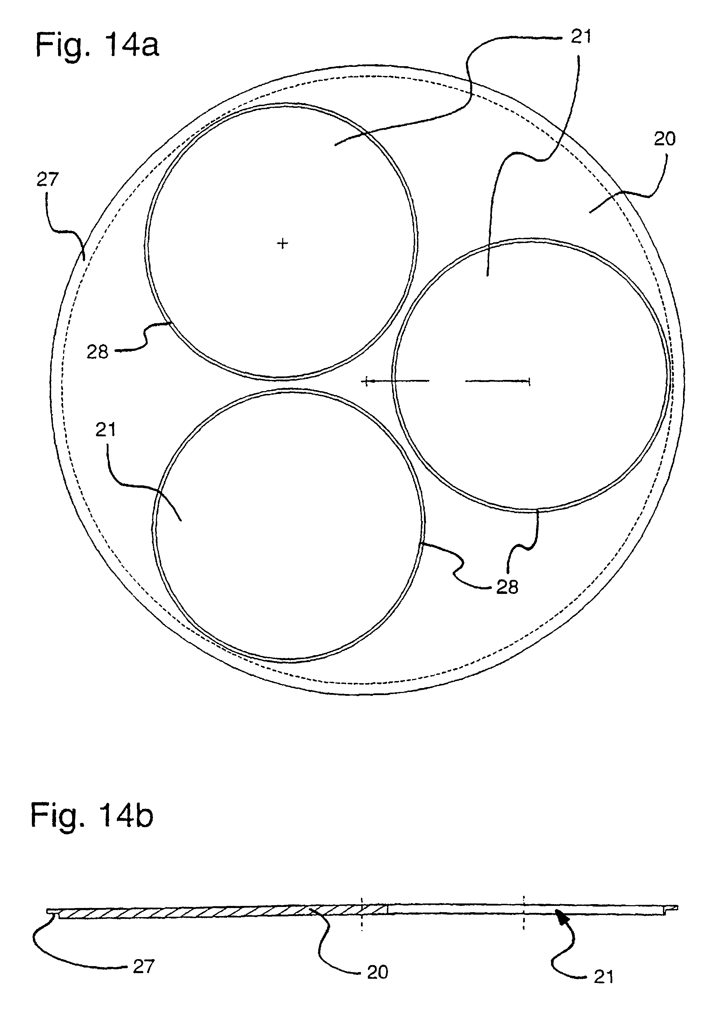

Fig. 14 a - b eine Draufsicht auf bzw. eine Schnittansicht durch eine zur Fig. 4 a analoge Ausführung einer Trägerscheibe, die auch als Drehteller zu bezeichnen ist, für drei 4"-Wafer der in der Fig. 5 gezeigten Ausführung der Vorrichtung zur Herstellung oxidischer Dünnschichten verdeutlicht, und

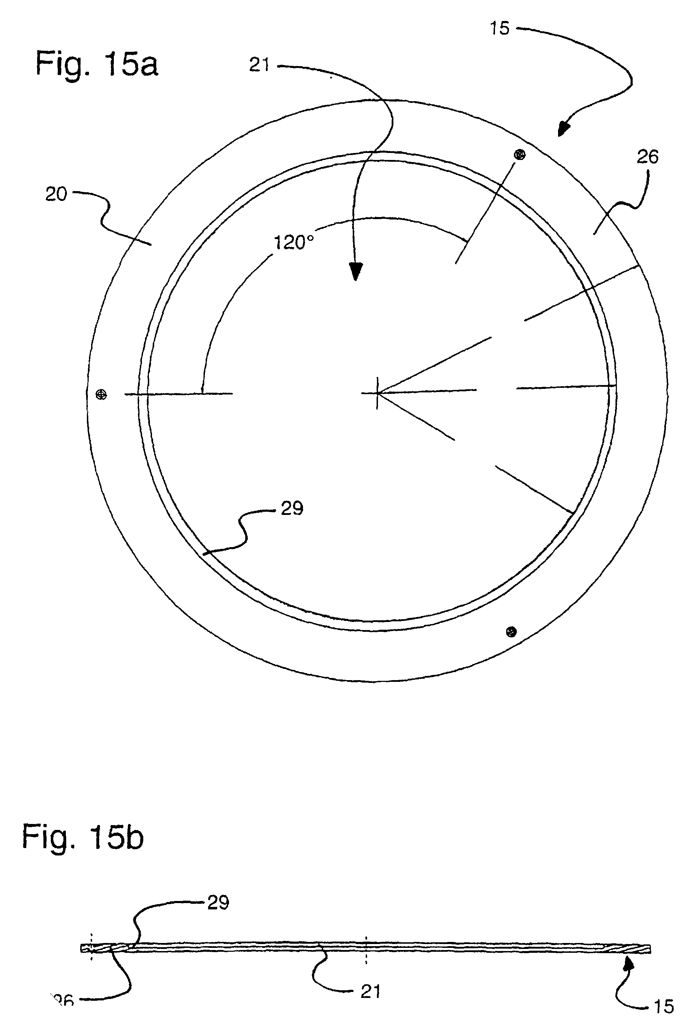

Fig. 15 a - b eine Draufsicht auf bzw. eine Schnittansicht durch eine weitere Ausführung einer Trägerscheibe für einen Wafer der in der Fig. 5 gezeigten Ausführung der Vorrichtung zur Herstellung oxidischer Dünnschichten sind.

In den einzelnen Darstellungen und Figuren der Zeichnung sind gleiche oder ähnliche sowie gleich oder ähnlich wirkende Teile durchgehend mit denselben Bezugszeichen versehen. Dadurch und durch die Darstellungen selbst sind einzelne Merkmale für den Fachmann erkennbar, auch wenn sie nicht oder nicht zu jeder der Figuren im einzelnen beschrieben sind.

Die Vorrichtung zur Herstellung oxidischer Dünnschichten enthält eine Vakuumkammer 1, wie sie der Prinzipdarstellung in der Fig. 2 zu entnehmen ist. Dort ist im oberen Teil der Vakuumkammer 1 auch ein Heizofen 2 mit Heizdrähten 3 zum Heizen eines Substrats 4 gezeigt. Im unteren Teil der Vakuumkammer 1, die über einen Absaugauslaß 5 mit einer Pumpe (nicht dargestellt) verbunden ist, befindet sich ein Verdampfer 6 mit einer Aufdampfsteuerung 7. Der Verdampfer 6 enthält bei dem gezeigten Beispiel drei Aufdampfvorrichtungen 8 in Form von Aufdampfschiffchen 9, von denen je eines zum Verdampfen von Y, Ba und Cu vorgesehen ist. Die Aufdampfsteuerung 7 steuert den Betrieb der Aufdampfvorrichtungen 8 in Abhängigkeit von Ratenmessern 10, die idealerweise für jedes Aufdampfschiffchen 9 getrennt vorhanden sind, auch wenn in der hier behandelten Prinzipskizze nur zwei davon gezeigt sind. Damit jeder Ratenmesser 10 möglichst nur die Verdampfungsrate von einem Aufdampfschiffchen 9 und somit von einem Material erfaßt, können, wie dies in der Fig. 2 angedeutet ist, jedem Ratenmesser 10 ein Kollimator 11 zugeordnet sind.

Unmittelbar unterhalb des das Substrat 4 optimalerweise zumindest im wesentlichen umgebenden Heizofens 2 ist ein Verschluß 12 angeordnet, um das Aufdampfen von aus den Aufdampfschiffchen 9 verdampften Material auf das Substrat definiert beginnen und beenden zu können.

Die vorstehend beschriebenen Komponenten sind ggf. mit den weiteren in der Beschreibungseinleitung angegebenen Merkmalen und Spezifikationen grundsätzlich auch bei einer Vorrichtung zur Herstellung oxidischer Dünnschichten gemäß der vorliegenden Erfindung vorhanden.

Wie schon in der Einleitung dieser Beschreibung im Zusammenhang mit der Fig. 2 angegeben wurde, wird beim Stand der Technik, wie er durch die Fig. 2 schematisch wiedergegeben wird, beispielsweise während des Verdampfungsvorgangs andauernd Sauerstoff zur Bedampfungsfläche des Substrats 4 zugeführt, um mit dem aufgedampften Metall permanent Oxid zu bilden. Alternativ war es bekannt, das Substrat 4 an einem Drehteller 13 zu halten und durch dessen Rotation wechselweise dem Metalldampf und dem Sauerstoff in einer Sauerstoffkammer 14 auszusetzen, wie es anhand der Fig. 3 beschrieben wurde.

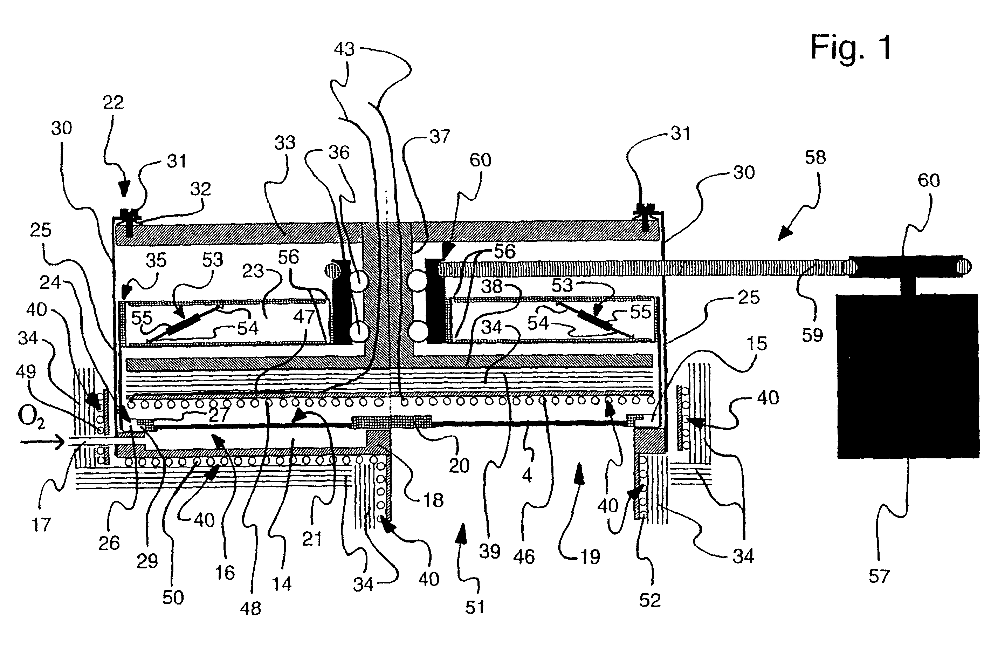

Basierend auf dem zweiteren Prinzip und unter Bezugnahme nunmehr auf die Fig. 1 enthält die Vorrichtung zur Herstellung oxidischer Dünnschichten gemäß der vorliegenden Erfindung neben oder statt den in den Fig. 2 und 3 dargestellten Komponenten einen Substrathalter 15, der so angeordnet ist, daß er eine Öffnung 16 einer Sauerstoffkammer 14 mit zumindest einer Sauerstoffzuführung 17 überdeckt. Der Substrathalter 15, der auch als Drehteller bezeichnet werden kann, ist kreisförmig und befindet sich oberhalb einer ebenfalls kreisförmigen Abschlußplatte 18, die in den Fig. 12 a und b gesondert dargestellt ist.

Wie insbesondere der Fig. 12 b zu entnehmen ist, ist die Sauerstoffkammer 14 direkt in der Abschlußplatte 18 ausgebildet und hat eine kreissegmentartige Form, die jedoch nicht bis zum Mittelpunkt des durch die Abschlußplatte 18 bestimmten Kreises reicht, wie in der Fig. 12 b zu erkennen ist. Weiterhin enthält die Abschlußplatte 18 einen kreissegmentförmigen Durchbruch, der als Ausschnittssegmentblende 19 fungiert, die im Gegensatz zur Sauerstoffkammer 14 jedoch bis zum Mittelpunkt des durch die Abschlußplatte 18 bestimmten Kreises reicht. Die Sauerstoffkammer 14 und die Ausschnittssegmentblende 19 sind in dem durch die Abschlußplatte 18 bestimmten Kreis symmetrisch angeordnet und erstrecken sich jeweils z.B. über 140°.

Eine nicht gesondert dargestellte Variante der Ausschnittssegmentblende 19 ist dergestalt, daß ihr Mittelpunkt auf der Achse des Substrathalters 15 liegt und sie insbesondere längs der radial verlaufenden Segmentseiten konkav nach innerhalb der Aufdampfzone eingezogen ist. Durch die Einwärtskrümmung der radial verlaufenden Segmentseiten der Ausschnittssegmentblende 19 wird die Wirkzeit der Bedampfung so gesteuert, daß möglichst keine höhere Schichtdicke im Bereich der Mitte des Radius der Ausschnittssegmentblende 19 erzeugt wird, da hier zum Ausgleich einer höheren Metalldampfkonzentration für die Metallatome nur eine kürzere Zeit zum Niederschlagen auf dem Substrat zur Verfügung steht. Durch die genaue Formgebung der radial verlaufenden Segmentseiten der Ausschnittssegmentblende 19 kann die aufgedampfte Schichtdicke über den gesamten Radius des Substrathalters, wenigstens soweit er von der Ausschnittssegmentblende 19 freigegeben ist, zumindest im wesentlichen konstant gehalten werden. Falls es erwünscht ist, kann aber auch ein bestimmtes Dickenprofil durch diese Maßnahme erzielt werden, wozu lediglich die Form der Ausschnittssegmentblende 19 entsprechend gewählt werden braucht.

Die Sauerstoffkammer 14 und die Ausschnittssegmentblende 19 sind auch in der Fig. 1 zu erkennen, der ferner zu entnehmen ist, daß der Substralhalter 15 eine Trägerscheibe 20 hält, in die beispielsweise durch geeignete Ausfräsungen 21 (siehe z.B. Fig. 14 a, b und 15 a, b) Substrate 4 eingelegt sind. Zum Positionieren und Drehen des Substrathalters 15 ist eine Drehhalterung vorgesehen, die allgemein mit 22 bezeichnet ist und im wesentlichen drei Dreharme 23 und letztere mit dem Rand oder allgemein Umfangsbereich 24 des Substrathalters 15 verbindende Abhängstreben 25 enthält. Dies bedeutet, daß die Drehhalterung 22 im Gegensatz zum in der Fig. 3 dargestellten Stand der Technik im Umfangsbereich 24 des Substrathalters 15 angreift. Die Drehhalterung 22 bzw. ihre Teile und insbesondere die Abhängstreben 25 bestehen zumindest im wesentlichen aus einem Material mit schlechter Wärmeleitung und einer möglichst geringen Wärmeausdehnung. So hat die Wärmeausdehnung geringste Auswirkungen auf Verziehen und Schlagen des Substrathalters 15 während seiner Drehung. Außerdem wird die Beschickung des Halters 15 mit Substraten 4 durch die Zwischenräume oder Abstände der Abhängstreben 25 wesentlich erleichtert.

Der Substrathalter 15 besteht aus einem Ring 26 mit eingelegter Trägerscheibe 20, die ihrerseits die Substrate 4 in Ausfräsungen 21 hält (siehe z.B. Fig. 14 a, b und 15 a, b), wie oben bereits erwähnt wurde. Dadurch können alle Substrate 4 gleichzeitig und sehr einfach seitlich eingesetzt oder entnommen werden. Dies ermöglicht auch eine Automatisierung der Beschickung mit Substraten 4. Beispiele möglicher Ausgestaltungen der Ausfräsungen 21 sind neben den Darstellungen in den Fig. 14 a, b und 15 a, b auch den Fig. 4 a - c zu entnehmen, wobei in letzteren auch eingelegte Substrate 4 dargestellt sind. Die Fig. 14 a, b und 15 a, b lassen darüber hinaus erkennen, daß sowohl die Trägerscheibe 20 an ihrem Außenumfangsrand, als auch die Ausfräsungen 21 an ihren Innenumfangsränder Schultern 27 bzw. 28 enthalten. Darüber stützen sich die Trägerscheibe 20 auf dem Ring 26 und die Substrate 4 auf der Trägerscheibe 20 ab. Es ist aber nicht unbedingt erforderlich, daß die Trägerscheibe 20 an ihrem Außenumfangsrand eine Schulterausbildung 27 hat. Alternativ oder zusätzlich kann beispielsweise (auch) der Ring 26 des Substrathalters 15 am Innenumfangsrand über eine Schulter 29 verfügen (siehe Fig. 1).

Die Aufhängung der Sauerstofftasche oder -kammer 14 erfolgt bei der in der Fig. 1 gezeigten Ausführung in ähnlicher Weise, wie die des Substrathalters 15. D.h., daß für die Sauerstoffkammer 14 ebenfalls drei Haltestreben 30 aus demselben Material wie die Abhängstreben 25 vorgesehen und diesen radial möglichst nahe benachbart angeordnet sind. Dadurch wird eine weitgehende gegenseitige Kompensation der Wärmeausdehnung der Abhängstreben 25 und der Haltestreben 30 erreicht, was zu einer geringstmöglichen Änderung der Spaltweite zwischen der Sauerstoffkammer 14 und dem Substrathalter 15 führt. Diesen Spalt möglichst klein zu halten ist deshalb erforderlich. da die mit Sauerstoff gefüllte oder gespülte Sauerstoffkammer 14 gegenüber dem übrigen Raum der Vakuumkammer abgedichtet werden muß, was nur durch die Schlitzdichtung bei möglichst geringem Abstand zwischen der Sauerstoffkammer 14 bzw. deren Öffnung 16 und dem Substrathalter 15 samt ggf. Trägerscheibe 20 und jedenfalls Substrat 4 gewährleistet ist.

Grundsätzlich können auch andere und jeweils verschiedene Anzahlen von Abhängstreben 25 und Haltestreben 30 vorgesehen sein, jedoch ist die hier behandelte Version mit jeweils drei Abhängstreben 25 und Haltestreben 30 besonders vorteilhaft und daher bevorzugt.

Wenn vorstehend von der Positionierung der Sauerstoffkammer 14 die Rede war, so ist damit im Zusammenhang mit der vorliegenden Ausführung die Positionierung der Abschlußplatte 18 gemeint, an deren Umfangsrand die Haltestreben 30 mit einem Ende angreifen. Das jeweils andere Ende der Haltestreben 30 ist über Schrauben 31 und ggf. Federmittel 32, wie beispielsweise Tellerfedern, an einer Deckplatte 33 einstellbar befestigt, die gesondert und mit weiteren Anbauteilen, auf die später eingegangen wird, in den Fig. 9 a und b gezeigt ist. Die Haltestreben 30 sind ferner in den Fig. 7, 8a und 9b gezeigt. Weitere Darstellungen der Abhängstreben 25 sind in den Fig. 7, 8b, 11a und 11 b enthalten.

Die Abhängstreben 25 und Haltestreben 30 haben jeweils einen möglichst geringen Querschnitt zur weiteren Verminderung der Wärmeleitung. Eine Ausführung der Abhängstreben 25 und Haltestreben 30 z.B. als Blechstreifen ergibt eine möglichst schmale Lücke zwischen Wärmeschilden 34, die den Raum um das Substrat soweit möglich vollständig umgeben. Dadurch wird eine gute Wärmeisolation der heißen Zone innerhalb der Wärmeschilde 34, wo analog dem Stand der Technik ein Heizofen 2 um das Substrat 4 herum aufgebaut ist, und eine geringere erforderliche Heizleistung sowie weniger Erwärmung der Aufdampfanlage gegenüber einem Zustand, bei dem zwischen einzelnen Wänneschilden 34 große Lücken bestehen.

Die Dreharme 23 bestehen bei der vorliegenden Ausführungsform aus rechteckig ausgefrästen Platten, d.h. sie haben die Form eines leeren Rechtecks. Die Seiten dieses Rechtecks haben jeweils einen möglichst geringen Querschnitt, was ebenfalls zur Reduktion der Wärmeleitung der Drehhalterung 22 beiträgt. Zwischen den Abhängstreben 25 und den Dreharmen 23 können sich noch Zwischenteile 35 mit besonders niedrigem Wärmeübergang befinden. Beispiele hierfür sind Untelagscheiben, Keramikteile usw.

Die Drehhalterung 22 ist mittels der Dreharme 23 über Kugellager 36 auf einer wassergekühlter feststehender Achse 37 drehgelagert. Durch einen kurzen Abstand zwischen dem Substrathalter 15 und den gekühlten Kugellagern 36, von denen im gezeigten Beispiel zwei vorhanden sind, wird eine erhöhte Stabilität erreicht. Die Kugellager 36 sind spielfrei gegeneinander verspannt.

Der Wärmeübergangswiderstand zwischen den Armen 23 des Karussells oder der Drehhalterung 22, die direkt an den Kugellagern 36 angreifen, und der Abhängung des Substrathalters 15 kann durch die vorerwähnten Zwischenteile 35 erhöht werden (z.B. durch Keramikbauteile), um ein Aufheizen der Kugellager über die Arme zu reduzieren.

Die Sauerstoffkammer oder -tasche 14 wird durch die Befestigungsschrauben 31 der Haltestreben 30 justiert. Die Befestigungsschrauben 31 werden, wie bereits weiter oben angegeben, durch die Tellerfedern 32 oder andere federnde Elemente elastisch gekontert. Durch diese Justierung kann erstens die Sauerstoffkammer 14 genau eben in Bezug auf die durch die Kugellager 36 definierte Achse oder Ebene eingestellt werden und zweitens die Spaltbreite zwischen der Sauerstoffkammer 14 und dem Substrathalter 15 auf einen optimalen Wert eingestellt werden.

Am unteren Ende der Achse 37 befindet sich ein Wärmeschild 34, das einen Kühlkörper 38 enthält, der zusammen mit der Achse 37 aus einem Stück gefertigt ist, und zwar aus gut wärmeleitendem Material. Dadurch wird der Kühlkörper 38 ebenfalls durch das Kühlwasser der Achse 37 gekühlt. Der Kühlkörper 38 des Wärmeschildes 34 schützt zusammen mit einem ebenfalls zu letzterem gehörenden zusätzlichen Stapel aus Folien 39 die Kugellager 36 vor der Wärmestrahlung von Heizeinrichtungen 40, die den beim Stand der Technik beschriebenen Heizofen 2 bilden. Das hier besprochene Wärmeschild 34 sorgt für eine temperaturmäßige Abschirmung der Kugellager 36 und der wassergekühlten feststehenden Achse 37.

Detaildarstellungen der feststehenden Achse 37 und des Kühlkörpers 38 sind in den Fig. 10 a - c gezeigt, wo der Kühlwasserkanal 41 und zwei Durchführungen 42 für Zuleitungen 43 (siehe Fig. 1) zu den Heizeinrichtungen 40 zu erkennen ist. Die dadurch hohle Achse 37 ist durch einen Deckel 44 verschlossen, der mittels Schrauben (nicht dargestellt) durch hierfür vorgesehene Gewindebohrungen 45 an der hohlen Achse 37 befestigt werden kann. Die Ausgestaltung des Kühlwasserkanals 41 kann in Abweichung von der dargestellten Version verschiedene Formen und Führungen aufweisen. Insbesondere können mehrere Kühlwasserkanale 41 in der Achse 37 und auch in dem Kühlkörper 38 enthalten sein oder auch außen daran angebracht sein.

Das Wärmeschild 34 an der Achse 37 befindet sich in dem zylindrischen Raum, der durch die Dreharme 23, die Abhängstreben 25 und den Substrathalter 15 begrenzt wird. An der Unterseite dieses Wärmeschildes 34, also zum Substrathalter 15 hin, befindet sich als Bestandteil der Heizeinrichtungen 40 eine Oberseitenheizung 46. Diese enthält eine Heizplatte 47, auf der Mantelheizleiter 48 möglichst dicht angeordnet sind. Dadurch ergibt sich eine große abstrahlende Heizerfläche und somit für eine gegebene Strahlungsleistung eine möglichst niedere Temperatur der Heizleiter 48. Dies führt zu einem geringeren Abdampfen von Verunreinigungen, d.h. zu einer besseren Qualität der herzustellenden Dünnschichten. Außerdem hat die möglichst niedrige Temperatur der Mantelheizleiter 48 deren längere Lebensdauer zur Folge.

Wie besonders gut an der Fig. 1 zu erkennen ist, enthalten die Heizeinrichtungen 40 ferner eine Umfangsheizung 49, die die Drehhalterung 22 im Bereich des Substrathalters 15 und außerhalb der Haltestreben 30 umgibt, jedoch innerhalb des entsprechenden, bereits im Zusammenhang mit der Lücke zwischen den Haltestreben 30 und den Abhängstreben 25 angegebenen Wärmeschildes 34 angeordnet ist, das die durch die Heizeinrichtungen 40 gebildete heiße Zone auch hier umfangsmäßig abschließt. Auch unterhalb des Substrathalters 15 ist eine Unterseitenheizung 50 angebracht, die die gesamte Fläche der Abschlußplatte 18 mit Ausnahme der Ausschnittssegmentblende 19 bedeckt. Die mit der Unterseitenheizung 50 bedeckte Fläche ist zum übrigen Raum hin wiederum mittels eines Wärmeschildes 34 abgeschirmt. Auch die Umfangsheizung 49 und die Unterseitenheizung 50 enthalten Heizplatten 47, auf denen Mantelheizleiter 48 aus denselben Gründen und mit denselben Vorteilen wie bei der Oberseitenheizung 46 möglichst dicht angeordnet sind.

Die Heizungen 46, 49 und 50 schließen den Proben- oder Substrathalter 15 von allen Seiten ein, um eine Hohlraumstrahlung anzunähern. Dazu ist ferner im Bereich der Ausschnittssegmentblende 19 ein Kamin 51 vorgesehen, der den Weg des von den Aufdampfschiffchen 9 verdampften Materials zum Substrat 4 begrenzt. Der Kamin 51 ist an seiner Außenseite, d.h. der dem Metalldampfweg abgewandten Seite ebenfalls mit einer Kaminheizung 52 versehen, die wiederum dicht gelegte Mantelheizleiter 48 enthält. Damit kann auf der ganzen zu bedampfenden Fläche des Substrates 4 eine möglichst homogene Temperatur gewährleistet werden.

Die Mantelheizleiter 48 sind ohne Hartlöten an den Heizplatten 47 bzw. eventuell direkt auf der Außenseite des Kamins 51 z.B. durch Anbinden mit einem dünnem Edelstahldraht befestigt. Diese Anbringungsart vermeidet abdampfende Verunreinigungen aus einem Lot, führt zu weniger mechanischen Spannungen beim Erwärmen und Abkühlen und somit zu einer längeren Lebensdauer der Heizerelemente. Die Stromzuführung zu den Bestandteilen der Heizeinrichtung 40 wird dadurch ermöglicht, daß die Zuleitungen 43 in der Achse 37 für die Kugellager 38 geführt werden. Die Zuleitungen 43 befinden sich in Bohrungen oder Durchführungen 42 der Achse 37 neben dem Kanal oder den Kanälen 41 der Wasserkühlung.

Der Substrathalter 15 wird durch Stellvorrichtungen 53, die den Dreharmen 23 zugeordnet sind, justiert. Bei der gezeigten Ausführung (siehe Fig. 1, 7, 11 a und insbesondere 11 c) wird jede Stellvorrichtung 53 durch zwei hinsichtlich der Rechteckform der Dreharme 23 schräg (annähernd diagonal) gestellte Schraubenbolzen 54 und eine für diese gemeinsame Muffe 55 gebildet. Die beiden Schraubenbolzen 54 werden durch die Muffe 55 mit einem Schraubinnengewinde zusammengehalten. Die Bolzen 54 und die Muffe 55 haben rechts/links-Gewinde oder Differentialgewinde mit unterschiedlichem Gewindehub. Die Verstellung der Muffe 55 bewirkt somit eine Kontraktion oder Streckung der Anordnung und damit eine elastische Deformation des Dreharms 23 in die Form eines Parallelogramms. Dies führt zu einer Anhebung oder Absenkung der Abhängstreben 25. Damit kann der Substrathalter 15 genau eben in Bezug auf die durch die Kugellager 36 definierte Achse oder Ebene eingestellt werden. Auch durch diese Einstellmöglichkeit kann die Spaltbreite zwischen der Sauerstoffkammer 14 und dem Substrathalter 15 auf einen optimalen Wert eingestellt werden.

Einerseits zur Erleichterung der Deformation der Dreharme 23 und andererseits für eine möglichst geringe Wärmeübertragung enthalten die Dreharme 23 nahe ihren Ecken Einschnitte 56.

Ein Motor 57 zum Antrieb des Drehtellers oder des Substrathalters 15 über die kugelgelagerte Drehhalterung 22 ist innerhalb der Aufdampfanlage, d.h. innerhalb der Vakuumkammer 1 angeordnet und mit einer wassergekühlten Manschette (in den Schemadarstellungen nicht sichtbar) versehen. Dadurch wird eine Drehdurchführung, die i.d.R. nur eine kurze Lebensdauer hat, vermieden. Neben der Kühlung des Motors 57 mit einer wassergekühlten Manschette tragen die entsprechenden Wärmeschilde 34 zur Vermeidung einer Überhitzung des Motors 57 bei.

Ferner sind durch den Wegfall einer Drehdurchführung durch eine Wand der Vakuumkammer 1, die beispielsweise ein Box-Coater sein kann, der Drehteller oder Substrathalter 15 und der Motor 57 als kompakte Einheit leicht auszubauen, was Erleichterungen z.B. bei Service- und Einstellarbeiten zur Folge hat. Wenn, was in der Zeichnung nicht gesondert dargestellt, dem Fachmann aber ohne weiteres klar ist, zumindest Baueinheiten auf Schubladenschienen aus dem Gesamtgerät bzw. der Vakuumkammer 1 herausziehbar installiert sind, wird der Service weiter erleichtert.

Die Kraftübertragung zwischen dem Motor 57 und der kugelgelagerten Drehhalterung 22 und somit dem Substrathalter 15 erfolgt durch eine Transmission 58 aus Metall, wie z.B. eine Schraubenfeder 59 mit Schnurrädern 60, eine Kette mit Kettenrädern oder ein Zahnradgetriebe. Dadurch besteht keine Gefahr einer thermischen Zersetzung der Transmission 58. Eine metallische Transmission 58 mit beispielsweise einer Metallspiralfeder 59, die über Schnurräder 60 läuft, kann bei Stillstand der Drehhalterung 22 nicht durch die von den Heizeinrichtungen 40 ausgehende Hitze beschädigt, wie z.B. verbrannt werden, was zur Verunreinigung des Filmmaterials führen würde.

Materialien, die in der heißen Zone, d.h. innerhalb der Heizungen 46, 49 und 50 sowie ggf. 52 verwendet werden, sind Edelstahl oder spezieller Hochtemperaturstahl (z.B. Inconel). Alternativ können einige oder alle Teile des Gesamtgerätes aus Keramik ausgeführt sein. Dadurch können eine noch bessere Maßhaltigkeit und insbesondere eine noch geringere Spaltbreite zwischen dem Substrathalter 15 und der Sauerstoffkammer 14 sowie eine höhere Hochtemperaturformstabilität und noch geringere Toleranzen realisiert werden. Dies hat wiederum einen noch geringeren Sauerstofffluß, eine geringere erforderliche Pumpleistung und die Möglichkeit zur Verwendung noch größerer Substrathalter 15 zur Folge.

Wegen der Einfachheit der Vorgabe nicht gesondert dargestellt ist die Anordnung der Aufdampfschiffchen 9 unterhalb des Drehtellers oder Substrathalters 15 im Bereich der Ausschnittssegmentblende 19. Die Anordnung der Aufdampfschiffchen 9 ist nämlich bei der vorliegenden Ausführung derart, daß ihre Mittelpunkte einen Kreis bilden, dessen Radius zumindest annähernd halb so groß wie der des Substrathalters 15 oder der Trägerscheibe 20 ist und dessen Mittelpunkt sich senkrecht unterhalb des Mittelpunkts des Substrathalters 15 befindet. Genauer ist der Durchmesser des Anordnungskreisbogens der Aufdampfschiffchen 9 bei der vorliegenden Ausführung möglichst genau halb so groß, wie der Radius, der der Ausschnittssegmentblende 19 zu Grunde liegt. Dadurch werden Konzentrationsgradienten bei Dünnschichten, die mehrere Metallkomponenten enthalten vermieden.

Um in-situ Pufferschichten und Deckschichten herstellen zu können, die beispielsweise für Mikrowellenfilter wichtig sind, ist eine Elektronenstrahlkanone beweglich in der Aufdampfanlage montiert, so daß sie über die Aufdampfschiffchen 9 bewegt werden kann. Auch eine Darstellung hiervon ist wegen der Einfachheit der Maßgabe für den Fachmann entbehrlich.

Die Stabilität der Schlitzdichtung erlaubt bei dem vorliegenden Ausführungsbeispiel, das bereits in der Praxis erprobt wurde, selbst bei großem Durchmesser des Substrathalters 15, Schlitzweiten zwischen letzterem und der Sauerstoffkammer 14 unter 0,3 mm und damit Druckgradienten von 1000:1 bei sehr ökonomischer Pumpleistung.

Besonders durch die Kombination der verstellbar Abhängung der Sauerstofftasche oder -kammer 14 von der kalten Deckplatte 33 her mit den verstellbaren Dreharmen 23, die z.B. die weiter oben beschriebenen Stellvorrichtungen 53 und die durch die Einschnitte 56 in den Ecken der Rechteckform der Dreharme 23 gebildeten Schwachstellen enthalten, erlaubt eine besonders gute, einfache und optimale Einstellung der Schlitzweite zwischen dem Substrathalter 15 und der Sauerstoffkammer 14. Durch diese Verstellbarkeit wird ferner eine Einstellung des Rotationsmittelpunktes und der Parallelität des Substrathalters 15 zur Sauerstoffkammer 14 ermöglicht. Diese Einstellungen bleiben auch bei Temperaturänderungen weitgehend stabil, wenn die Abhängung der Sauerstofftasche 14 und des Substrathaltcrs 15 durch Material mit derselben Wärmeausdehnung erfolgt. Damit wird eine Verstellung der Schlitzweite zumindest weitgehend vermieden.

Die Heizung des Substrats oder der Substrate 4 erfolgt durch fixierte Heizungen 46, 49 und 50 sowie ggf. 52, d.h. unterhalb der kalten Deckplatte 33 zusätzlich von dieser abgeschirmt durch Strahlungs- oder Wärmeschilde 34, Heizwicklungen um die Sauerstoffkammer und einen Umfangsheizer über den Umfangsrand des Substrathalters 15, was zu einer nahezu geschlossenen Ofengeometrie führt und eine homogene Temperatur über die gesamte zu bedampfende Fläche gewährleistet. Strahlungsverluste können allenfalls nur durch die Aufdampfzone auftreten und werden dort durch die Kaminheizung minimiert. Die Abschirmbleche oder Wärmeschilde 34 verringern Wärmeverluste aus der heißen Zone, so daß die Leistungsaufnahme der Heizeinrichtungen 40 auf ein Minimum beschränkt werden kann.

Das Heizfilament (Thermocoax) ist in dieser Anordnung durch einen Metalldraht an Ort und Stelle fixiert und nicht hartgelötet, da durch letzteres auf die Dauer durch Zersetzung und Abdampfen eine Verunreinigung des Filmmaterials erfolgen würde.

Weitere Einzelheiten der vorstehend behandelten Ausführungsbeispiels der Vorrichtung zur Herstellung oxidischer Dünnschichten sind den weiteren Abbildungen der Zeichnung zu entnehmen, soweit nicht ohnehin bereits darauf eingegangen wurde.

Die Figuren 5, 6, 7, 9a und 9b zeigen in verschiedenen Ansichten weitere Details der verschiedenen Komponenten. Insbesondere ist diesen Konstruktionszeichnungen zu entnehmen, wie der Motor 57 bei der vorliegenden Ausführung über Zwischenplatten 61, 62 an der Deckplatte 33 befestigt ist.

Die Figuren 8a, 8b, 8c, 11a und 11 b geben weiteren Aufschluß über die Formen von Dreharm 23 (im Querschnitt), Abhängstrebe 25 und Haltestrebe 30 sowie deren Befestigungsvarianten aneinander bzw. an der Achse 37.

In den Fig. 13 a und b ist die Heizplatte 47 der Oberseitenheizung 46 dargestellt. Dabei ist ebenso wie in der Abbildung der Fig. 10 a bzw. in Zusammenschau mit dieser verständlich, daß diese Heizplatte 47 über Schrauben (nicht dargestellt) mit dem Kühlkörper 38 des entsprechenden Wärmeschildes 34 an der Achse 37 verbunden ist, und zwar durch die in den jeweiligen Figuren eingezeichneten Bohrungen. Diese Art der Befestigung der Heizplatte 47 an dem gekühlten Kühlkörper 38 sorgt für eine möglichst geringe Wärmeübertragung von der Heizplatte 47 auf den Kühlkörper 38.

Die vorliegende Erfindung ist nicht auf die im Zusammenhang mit konkreten Ausführungsbeispielen angegebene Beschreibung beschränkt, die lediglich exemplarisch zu verstehen ist.

Insbesondere ist im Rahmen der Erfindung wesentlich, daß bei einer Vorrichtung zur Herstellung oxidischer Dünnschichten, mit einer Vakuumkammer, in der eine Sauerstoffkammer mit einer Öffnung und ein letztere überdeckender drehbarer Substrathalter angeordnet sind, zur drehbaren Anordnung des Substrathalters eine Drehhalterung vorgesehen ist, die in einem Umfangsbereich des Substrathalters angreift. Hierbei können verschiedene Einstellmöglichkeiten der Drehhalterung, des Substrathalters und der Sauerstoffkammer bzw. deren Öffnung vorgesehen werden, ohne über die Erfindung hinauszugehen. Die Erfindung ist ferner nicht auf die Bauart des Substrathalters beschränkt, die in den Figuren dargestellt und entsprechend beschrieben ist. Es können auch andere Formen, Aufnahmekapazitäten und Mechaniken z.B. zum Wenden der Substrate zum Einsatz kommen. Die Anordnungen und Gestaltungen von Wärmeschilden und Heizungen sind nicht abschließend wiedergegeben und daher auch nicht beschränkend zu verstehen.

Die Anordnung des Motors innerhalb der Vakuumkammer alleine und in Verbindung mit einer metallischen Transmission führt zu eigenständigen Vorteilen und ist daher ggf. auch losgelöst von der Verbindung des Substrathalters von der Drehhalterung zu sehen. Dies gilt auch für die Anordnung der wenigstens einen Aufdampfvorrichtung, die Gestaltung der Ausschnittssegmentblende, die Ausführung der Achse für die Drehhalterung, insbesondere in Verbindung mit dem Kühlkörper, und den Kamin, vorzugsweise einschließlich seiner Kaminheizung.

## Patentansprüche

1. Vorrichtung zur Herstellung oxidischer Dünnschichten mit einer Vakuumkammer (1), in der eine Sauerstoffkammer (14) mit einer Öffnung (16) und eine Aufdampfzone räumlich getrennt voneinander angeordnet sind, wobei ein die Öffnung (16) überdeckender, drehbarer substrathalter (15), der sich bis in die Aufdampfzone hinein erstreckt, angeordnet ist, und wobei zur drehbaren Anordnung des Substrathalters (15) eine Drehhalterung (22) vorgesehen ist, die in einem Umfangsbereich (24) des Substrathalters (15) angreift.

2. Vorrichtung zur Herstellung oxidischer Dünnschichten nach Anspruch 1, **dadurch gekennzeichnet, daß** die Drehhalterung eine Einstellung der Neigung oder des Abstandes des Substrathalters (15) von der Öffnung (16) der Sauerstoffkammer (14) zuläßt und daß die Drehhalterung einzelne voneinander beabstandete Dreharme (23) und diesen zugeordnete Abhängstreben (25) enthält, die im Umfangsbereich (24) des Substrathalters (15) angreifen und die Dreharme (23) mit dem Substrathalter verbinden, wobei zumindest ein Dreharm (23) zum Verstellen des Abstandes des Substrathalters (15) von der Öffnung (16) der Sauerstoffkammer (14) justierbar ist und die Sauerstoffkammer (14) über justierbare Haltestreben (30) positioniert ist, die hinsichtlich der Abhängstreben (25) der Drehhalterung (22) zumindest weitgehend parallel verlaufen und auf einem geringfügig größeren Kreisumfang liegen und die Abhängstreben (25) der Drehhalterung (22) und die Haltestreben (30) der Sauerstoffkammer (14) dasselbe Material enthalten oder aus demselben Material bestehen und dieselben oder ähnliche Querschnitte aufweisen.

3. Vorrichtung zur Herstellung oxidischer Dünnschichten nach einem der vorhergehenden Ansprüche, **dadurch gekennzeichnet, daß** der Substrathalter (15) einen Ring (26) enthält, in den wenigstens eine Trägerscheibe (20) einlegbar ist, die zum haltenden Aufnehmen von zumindest einem Substrat (4) ausgelegt ist

4. Vorrichtung zur Herstellung oxidischer Dünnschichten nach einem der vorhergehenden Ansprüche, **dadurch gekennzeichnet, daß** die Drehhalterung an einer feststehenden Achse (37) drehbar gelagert ist und daß die feststehende Achse (37) gekühlt ist, wobei die Lagerung der Drehhalterung (22) des Substrathalters (15) nahe bei letzterem liegt, wobei an der feststehenden Achse (37) zwischen der Lagerung der Drehhalterung (22) des Substrathalters (15) und dem Substrathalter (15) ein Wärmeschild (34) angeordnet ist und die feststehende Achse (37) und das Wärmeschild (34) im wesentlichen aus einem gut wärmeleitendern Material bestehen, wobei weiterhin
a) das Wärmeschild (34) einen an die Kühlung der feststehenden Achse angeschlossenen Kühlkörper (38) enthält und
b) zwischen dem Wärmeschild (34) und dem Substrathalter (15) eine Oberseitenheizung (46) vorgesehen ist, die durch die feststehende Achse (37) hindurch betriebsmäßig versorgt wird.

5. Vorrichtung zur Herstellung oxidischer Dünnschichten nach einem der vorhergehenden Ansprüche, **dadurch gekennzeichnet, daß** um den Umfangsverlauf des Substrathalters (15) eine Umfangsheizung (49) vorgesehen ist und daß die Sauerstoffkammer (14) mittels einer an deren dem Substrathalter (15) abgewandten Seite angeordneten Unterseitenheizung (50) geheizt wird und daß im Bereich des Substrathalters (15) außerhalb der Sauerstoffkammer (14) die Aufdampfzone gebildet ist, die durch einen zum Substrathalter (15) hin gerichteten Aufdampfkamin (51) begrenzt ist und daß eine Kaminheizung (52) zum Heizen des Aufdampfkamins (51) vorgesehen ist und daß für den Substrathalter (15) auf seiner dem Aufdampfkamin (51) zugewandten Seite in seinem außerhalb des Aufdampfkamins (51) liegenden Bereich eine Unterseitenheizung (50) angeordnet ist, wobei die Umfangsheizung (49) und die Unterseitenheizung (50) auf ihren dem Substrathalter (15) abgewandten Seiten thermisch abgeschirmt sind und die Kaminheizung (52) auf ihrer dem Aufdampfkamin (51) abgewandten Seite thermisch abgeschirmt ist.

6. Vorrichtung zur Herstellung oxidischer Dünnschichten nach einem der Ansprüche 4 oder 5, **dadurch gekennzeichnet, daß** die Oberseitenheizung (46) die Umfangsheizung (49), die Unterseitenheizung (50) und die Kaminheizung (52) Mantelheizleiter (48) enthalten.

7. Vorrichtung zur Herstellung oxidischer Dünnschichten nach einem der vorhergehenden Ansprüche, **dadurch gekennzeichnet, daß** im Bereich des Substrathalters (15) außerhalb der Sauerstoffkammer (14) die Aufdampfzone in Form eines Kreissegmentes gebildet und durch eine Ausschnittssegmentblende (19) begrenzt ist, deren Mittelpunkt auf der Achse des Substrathalters (15) liegt und die längs der radial verlaufenden Segmentseiten konkav nach innerhalb der Aufdampfzone eingezogen ist, und
daß zum Antrieb der Drehhalterung (22) ein Motor (57) innerhalb der Vakuumkammer (1) angeordnet ist, der im Bereich der Lagerung der Drehhalterung (22) an der feststehenden Achse (37) antriebsmäßig mit der Drehhalterung (22) gekoppelt ist.

8. Vorrichtung zur Herstellung oxidischer Dünnschichten nach einem der vorhergehenden Ansprüche, **dadurch gekennzeichnet, daß** in der Vakuumkammer (1) Schubladenschienen angeordnet sind, auf denen einzelne innerhalb der Vakuumkammer liegende Baugruppen der Vorrichtung ganz oder teilweise nach außerhalb der Vakuumkammer (1) verschiebbar sind; und
daß einzelne Komponenten ganz oder teilweise aus Edelstahl, Hochtemperaturstahl oder Keramik bestehen und daß die Drehhalterung (22) und der Substrathalter (15) ganz oder teilweise aus einem Material mit geringer Wärmeleitfähigkeit und Wärmeausdehnung bestehen.

9. Vorrichtung zur Herstellung oxidischer Dünnschichten nach einem der vorhergehenden Ansprüche, **dadurch gekennzeichnet, daß** wenigstens eine Aufdampfvorrichtung (8) vorgesehen ist, die außerhalb der Sauerstoffkammer (14) liegend und dem Aufdampfkamin (51) zugeordnet auf einer Kreislinie angeordnet ist, deren Radius zumindest ungefähr die Hälfte des Radius einer eine Aufdampfzone bestimmenden Ausschnittssegmentblende (19) mißt und deren Mittelpunkt mit der Achse des Substrathalters ausgerichtet ist.

10. Vorrichtung zur Herstellung oxidischer Dünnschichten nach einem der vorhergehenden Ansprüche, **dadurch gekennzeichnet, daß** eine Mehrzahl von Aufdampfvorrichtungen (8) und eine relativ dazu bewegliche Elektronenstrahlkanone vorgesehen sind.

## Claims

1. Apparatus for the production of thin oxide coatings with a vacuum chamber (1), in which an oxygen chamber (14) with an opening (16) and an evaporation zone is arranged spaced apart from each other, wherein a rotary substrate holder (15) is arranged, which covers the opening (16) and reaches into the evaporation zone, and wherein a rotary mounting (22) is provided which engages a circumferential area (24) of the substrate holder (15) for a rotary arrangement of the substrate holder (15).

2. Apparatus for the manufacturing of thin oxide coatings according to claim 1, **characterized in that** the rotary mounting allows an adjustment of the tilt or the distance of the substrate holder (15) with respect to the opening (16) of the oxygen chamber (14) and that the rotary mounting comprises individual, spaced apart revolving arms (23) and overhead struts (25) associated with the latter, which engage the circumferential area (24) of the substrate holder (15) and connect the revolving arms (23) with the substrate holder, wherein at least one revolving arm (23) is adjustable for the adjusting of the distance of the substrate holder (15) with respect to the opening (16) of the oxygen chamber (14), and the oxygen chamber (14) is positioned via adjustable hanger struts (30) which are at least substantially parallel with respect to the overhead struts (25) of the rotary mounting (22) and which are arranged on a slightly larger circumference, and that the overhead struts (25) of the rotary mounting (22) and the hanger struts (30) of the oxygen chamber (14) comprise the same material or consist of the same material and comprise the same or similar sections.

3. Apparatus for the production of thin oxide coatings according to one of the previous claims, **characterized in that** the substrate holder (15) comprises a ring (26) in which at least one carrier plate (20) can be laid in which is provided for the holding of at least one substrate (4).

4. Apparatus for the production of thin oxide coatings according to one of the previous claims **characterized in that** the rotary mounting is rotatably mounted on a fixed shaft (37), and that the fixed shaft (37) is cooled, wherein the bearing of the rotary mounting (22) of the substrate holder (15) lies close to the latter, wherein a heat shield (34) is arranged at the fixed shaft (37) between the bearing of the rotary mounting (22) of the substrate holder (15) and the substrate holder (15), and that the fixed shaft (37) and the heat shield (34) substantially comprise of a material of good thermal conductivity, wherein further
a) the heat shield (34) comprises a cooling body (38) connected to the cooling of the fixed shaft, and
b) a top-side heater (46) is provided between the heat shield (34) and the substrate holder (15) and which is powered through the fixed shaft (37).

5. Apparatus for the production of thin oxide coatings according to one of the previous claims, **characterized in that** a circumferential heater (49) is provided around the circumference of the substrate holder (15), and that the oxygen chamber (14) is heated with a bottom-side heater (50), which is arranged at the opposite side of the substrate holder (15), and that an evaporation zone is formed in the area of the substrate holder (15) outside of the oxygen chamber (14), wherein the evaporation zone is defined by an evaporation flue (51) which is directed to the substrate holder (15), and that a flue heater (52) is provided for heating of the evaporation flue (51), and that a bottom-side heater (50) is arranged for the substrate holder (15) on its side directed towards the evaporation flue (51) in an area outside of the evaporation flue (51), wherein the circumferential heater (49) and the bottom-side heater (50) are thermally shielded on their sides facing away from the substrate holder (15), and that the flue heater (52) is thermally shielded at its side facing away from the evaporation flue (51).

6. Apparatus for the production of thin oxide coatings according to one of the claims 4 or 5, **characterized in that** the top-side heater (46), the circumferential heater (49), the bottom-side heater (50) and the flue heater (52) comprise jacket heater wires (48).

7. Apparatus for the production of thin oxide coatings according to one of the previous claims, **characterized in that** in the area of the substrate holder (15) outside of the oxygen chamber (14) the evaporation zone is formed in the shape of a sector, and that the evaporation zone is defined by a sector shaped cut-out mask (19) whose centre point lies on the axis of the substrate holder (15) and which is drawn concavely within the evaporation zone along the radially running sector sides, and
that for the driving of the rotary mounting (22) a motor (57) is arranged within the vacuum chamber (I) which is drivingly coupled with the rotary mounting (22) in the area of the bearing of the rotary mounting (22) on the fixed shaft (37).

8. Apparatus for the production of thin oxide coatings according to one of the previous claims, **characterized in that** draw slides are arranged within the vacuum chamber (1) onto which individual components of the apparatus that lie within the vacuum chamber can be wholly or partially be removable to the outside of the vacuum chamber (1), and
that individual components consists wholly or partially out of stainless steel, high temperature steel or ceramics and that the rotary mounting (22) and the substrate holder (15) wholly or partially consist of a material with a low thermal conductivity and low thermal expansion.

9. Apparatus for the production of thin oxide coatings according to one of the previous claims, **characterized in that** at least one vapor depositing device (8) is provided which lies outside of the oxygen chamber (14) and is associated with the vapor depositing flue (51), is disposed on a circle whose radius measures at least approximately one half of the radius of a sector shaped cut-out mask (19) which defines the vapor depositing zone and whose centre point is aligned with the axis of the substrate holder.

10. Apparatus for the production of thin oxide coatings according to one of the previous claims, **characterized in that** a plurality of vapor depositing devices (8) and an electron beam gun are provided, which is moveable relatively thereto.

## Revendications

1. Dispositif pour fabriquer des couches d'oxyde minces comportant une chambre à vide (1), dans laquelle sont disposés côte-à-côte d'une manière séparée spatialement, une chambre à oxygène (14) pourvue d'une ouverture (16) et une zone de dépôt par évaporation,
et dans lequel il est prévu un porte-substrat rotatif (15), qui recouvre l'ouverture (16) et s'étend jusqu'à l'intérieur de la zone de dépôt par évaporation, et dans lequel pour le montage rotatif du porte-substrat (15), il est prévu un support rotatif (22), qui attaque une partie périphérique (21) du porte-substrat (15).

2. Dispositif pour fabriquer des couches d'oxyde minces selon la revendication 1, **caractérisé en ce que**, le support rotatif permet un réglage de l'inclinaison ou de la distance du porte-substrat (15) par rapport à l'ouverture (16) de la chambre à oxygène (14) et que le support rotatif contient des bras rotatifs individuels (23) distants les uns des autres et des entretoises de suspension (25) associées à ces bras et qui attaquent la partie périphérique du porte-substrat (15) et relient les bras rotatifs (23) au porte-substrat, au moins un bras rotatif (23) pouvant être ajusté pour le réglage de la distance du porte-substrat (15) par rapport à l'ouverture (16) de la chambre à oxygène (14), et la chambre à oxygène (14) étant positionnée au moyen d'entretoises de retenue ajustables (30), qui s'étendent au moins dans une large mesure parallèlement aux entretoises de suspension (25) du support rotatif (22) et sont situées sur la périphérie circulaire légèrement plus grande, et les entretoises de suspension (25) du support rotatif (22) et les entretoises de retenue (30) de la chambre à oxygène (14) contiennent le même matériau et sont constituées par le même matériau et possèdent des sections transversales identiques ou similaires.

3. Dispositif pour fabriquer des couches d'oxyde minces selon l'une des revendications précédentes, **caractérisé en ce que** le porte-substrat (15) contient un anneau (26), dans lequel peut être inséré au moins un disque de support (20), qui est conçu pour recevoir, en le retenant, au moins un substrat (4).

4. Dispositif pour fabriquer des couches d'oxyde minces selon l'une des revendications précédentes, **caractérisé en ce que** le support rotatif est monté de manière à pouvoir tourner sur un axe fixe (37), et que l'axe fixe (37) est refroidi, le tourillonnage du support rotatif (22) du porte-substrat (15) étant situé à proximité de ce dernier, un bouclier thermique (34) étant disposé sur l'axe fixe (37) entre le tourillonnage du support rotatif (22) du porte-substrat (15), et le porte-substrat (16) et l'axe fixe (37) et le bouclier thermique (34) étant constitués essentiellement par un matériau bon conducteur de la chaleur, et dans lequel
a) le bouclier thermique (34) contient un corps de refroidissement (38) raccordé au système de refroidissement de l'axe fixe, et
b) entre le bouclier thermique (34) et le porte-substrat (15) est prévu un dispositif de chauffage (46) situé côté supérieur et qui est alimenté en fonctionnement par l'intermédiaire de l'axe fixe (34).

5. Dispositif pour fabriquer des couches d'oxyde minces selon l'une des revendications précédentes, **caractérisé en ce qu'**un dispositif de chauffage périphérique (49) est disposé autour de la périphérie du porte-substrat (15) et que la chambre à oxygène (14) est chauffée au moyen d'un dispositif de chauffage (50) situé côté inférieur et qui est disposé sur le côté de cette chambre tournée à l'opposé du porte-substrat (15), et que dans la zone du porte-substrat (15) à l'extérieur de la chambre à oxygène (14) est formée la zone de dépôt par évaporation, qui est délimitée par une cheminée de dépôt par évaporation (51) dirigée vers le porte-substrat (15) et qu'un dispositif de chauffage de cheminée (52) est prévu pour le chauffage de la cheminée de dépôt par évaporation (51) et qu'un dispositif de chauffage (50) sur le côté inférieur est prévu pour le porte-substrat (15) sur le côté de ce dernier, qui est tourné vers la cheminée de dépôt par évaporation (51), dans sa partie située à l'extérieur de cette cheminée de dépôt par évaporation (51), le dispositif de chauffage périphérique (49) et le dispositif de chauffage côté inférieur (50) étant protégés thermiquement sur leurs côtés tournés à l'opposé du porte-substrat (15), et le dispositif de chauffage de la cheminée (52) étant protégé thermiquement sur son côté tourné à l'opposé de la cheminée de dépôt par évaporation (51).

6. Dispositif pour fabriquer des couches d'oxyde minces selon l'une des revendications 4 ou 5, **caractérisé en ce que** le dispositif de chauffage côté supérieur (46), le dispositif de chauffage côté inférieur (50) et le dispositif de chauffage de cheminée (52) contiennent des conduits de chaleur enveloppants (48).

7. Dispositif pour fabriquer des couches d'oxyde mince selon l'une des revendications précédentes, **caractérisé en ce que** dans la zone du porte-substrat (15), à l'extérieur de la chambre à oxygène (14), la zone de dépôt par évaporation est réalisée sous la forme d'un segment de cercle et est délimitée par un diaphragme en forme de segment découpé (19), dont le centre est situé sur l'axe du porte-substrat (15) et qui est inséré avec une forme concave, le long des côtés radiaux du segment, vers l'intérieur de la zone de dépôt par évaporation, et que pour le fonctionnement du support rotatif (22) il est prévu, à l'intérieur de la chambre à vide (1), un moteur (57), qui est couplé, selon une liaison motrice, au support rotatif (22) dans la zone du tourillonnage du support rotatif (22) sur l'axe fixe (37).

8. Dispositif pour fabriquer des couches d'oxyde minces selon l'une des revendications précédentes, **caractérisé en ce que** dans la chambre à vide (1) sont disposés des rails de tiroir, sur lesquels des modules individuels du dispositif, qui sont situés à l'intérieur de la chambre à vide, peuvent être déplacés par translation, en totalité ou en partie vers l'extérieur de la chambre à vide (1); et
que des composants individuels sont constitués en totalité ou en partie par un acier spécial, un acier résistant aux hautes températures ou une céramique, et que le support rotatif (22) et le porte-substrat (15) sont constitués en totalité ou en partie par un matériau présentant une faible capacité calorifique et une faible dilatation thermique.

9. Dispositif pour fabriquer des couches d'oxyde minces selon l'une des revendications précédentes, **caractérisé en ce qu'**il est prévu au moins un dispositif de dépôt par évaporation (8), qui est disposé à l'extérieur de la chambre à oxygène (14) et, en étant associé à la cheminée de dépôt par évaporation (51), sur une ligne circulaire, dont le rayon est égal au moins approximativement à la moitié du rayon d'un diaphragme en forme de segment découpé (19), qui détermine une zone de dépôt par évaporation et dont le centre est aligné avec l'axe du porte-substrat.

10. Dispositif pour fabriquer des couches d'oxyde minces selon l'une des revendications précédentes, **caractérisé en ce qu'**il est prévu une multiplicité de dispositifs de dépôt par évaporation (8) et un canon à électrons déplaçable par rapport à ces dispositifs.
